# EUROPEAN PATENT APPLICATION

(11) **EP 2 785 152 A1**
(43) Date of publication of application: **01.10.2014**
(21) Application number: 12851989.9
(22) Date of filing: 20.11.2012
(51) Int. Cl.: H05H 1/46, C23C 14/34, C23C 16/50, F25D 7/00, H01L 21/3065

(54) **PLASMA GENERATION SOURCE AND VACUUM PLASMA PROCESSING APPARATUS PROVIDED WITH SAME**

(30) Priority: 22.11.2011 JP 2011254695; 22.11.2011 JP 2011254696
(71) Applicant: Kabushiki Kaisha Kobe Seiko Sho (Kobe Steel, Ltd.), Kobe-Shi, Hyogo 651-8585 (JP)
(72) Inventor: TAMAGAKI, Hiroshi, Takasago-shi, Hyogo 676-8670 (JP)
(74) Representative: TBK
(86) International application number: PCT/JP2012/007441
(87) International publication number: WO 2013/076966

(57) **Abstract**

A plasma source that is uniformly and efficiently cooled, a vacuum plasma processing apparatus including the plasma source, and a plasma source cooling method are provided. The vacuum plasma processing apparatus includes a vacuum chamber of which the inside is evacuated to a vacuum state and a plasma source which is provided inside the vacuum chamber. The plasma source includes a plasma generation electrode that generates plasma inside the vacuum chamber and a reduced pressure space forming member that forms a reduced pressure space accommodating a liquid cooling medium and depressurizing at the back surface of the plasma generation electrode, and the plasma generation electrode is cooled by the evaporation heat generated when the cooling medium is evaporated by a depressurization.

## Description

### TECHNICAL FIELD

The present invention relates to a vacuum plasma processing apparatus that performs a plasma process such as a deposition process on a substrate by CVD or sputtering and to a plasma source of the vacuum plasma processing apparatus.

### BACKGROUND ART

For example, a vacuum plasma processing apparatus is used for a deposition process to be performed on a substrate by sputtering and plasma CVD. The vacuum plasma processing apparatus includes a vacuum chamber and a plasma source with an electrode for generating plasma in the vacuum chamber.

In the vacuum plasma processing apparatus, since a part or most of electric energy input to the plasma source is converted into thermal energy, a large thermal load is applied to the plasma source. Therefore, the vacuum plasma processing apparatus is provided with a cooling device that suppresses an increase in the temperature of the electrode contacting the plasma. For example, Patent Document 1 discloses a cooling device for a magnetron sputtering apparatus. Here, a cooling channel is provided behind a backing plate (an electrode plate) supporting a target, and the backing plate is cooled by cooling water supplied to the cooling channel. Specifically, in the cooling device, the circulation of the cooling water flowing along the cooling channel provided behind the backing plate cools the plasma source (in this case, a sputter source).

Incidentally, in a cooling system, that is, a water cooling system that circulates the cooling water along the cooling channel, the temperature of the cooling water gradually increases as the cooling water flows toward the downstream. For this reason, problems arise in that the backing plate may not be sufficiently cooled at a position close to the end of the cooling channel and the temperature of the position increases. Further, in the water cooling system, the length of the cooling channel needs to be increased when an increase in the size of the plasma source (the sputter source) is caused by an increase in the size of the vacuum plasma processing apparatus, and hence there is a tendency that the structure becomes complicated.

Further, in the water cooling system, the cooling water inside the cooling channel is divided into layers having different temperatures, and hence there is a possibility that a fluid film, that is, a laminar boundary layer may be formed between the layers. When the fluid film is formed in the cooling channel, the heat transfer efficiency is noticeably degraded. In order to avoid this problem, there is a need to employ a structure that promotes the generation of the turbulence flow inside the cooling channel or a flow velocity at which the turbulence flow is easily generated. This countermeasure generally increases the pressure loss caused by the circulation of the cooling water.

In addition, in Patent Document 1, the heat emitted to the plasma source is very large. Thus, there is a need to circulate a large amount of cooling water along the cooling channel in order to remove such large heat and sufficiently cool the backing plate. Further, in order to ensure the necessary cooling water amount, the cooling water supply pressure also needs to be increased, and hence a large pressure (water pressure) of 200 to 700 kPa needs to be applied to the back surface of the backing plate. Meanwhile, since the front surface of the backing plate is generally depressurized to 100 Pa or less, a vacuum pressure is applied to the water pressure, and hence a large pressure difference of, for example, 300 kPa or more occurs between the front and back surfaces of the backing plate. Therefore, there has been a demand for a secure cooling water sealing device or a secure backing plate that is not deformed or cracked even when such a large pressure difference is applied thereto.

That is, in the water cooling device disclosed in Patent Document 1, it is difficult to uniformly cool the plasma source. Then, in order to realize the uniform cooling operation, the cooling channel becomes complicated. When the heat is emitted to the outside of the water cooling type plasma source, a large amount of cooling water needs to be circulated to the back surface of the plasma generation electrode, and hence a system such as a large-scaled pump is needed. In addition, the backing plate needs to be thickened or the cooling water sealing device needs to be increased in size in order to withstand the pressure difference occurring between the front and back surfaces of the backing plate, and hence there is a high possibility that the manufacturing cost increases.

Further, in an apparatus that includes a magnetron sputter source in which an electrode is equipped with a magnetic field generation device, an increase in the thickness of the backing plate for preventing the large pressure difference causes a new problem. Specifically, an increase in the thickness of the backing plate increases the distance between the magnetic field generation device provided at the inside of the plasma source (the back surface side of the backing plate) and the front surface of the target provided at the outside of the plasma source (the front surface side of the backing plate), and the strength of the magnetic field applied from the magnetic field generation device to the target decreases as the distance increases. Thus, when the sufficient magnetic field strength needs to be obtained in the front surface of the target, a problem arises in that a large magnetic field generation device for generating a strong magnetic field is needed.

### CITATION LIST

### PATENT DOCUMENT

Patent Document 1: JP 5-148643 A

### SUMMARY OF THE INVENTION

An object of the present invention is to provide a plasma source capable of uniformly and effectively cooled while suppressing an increase in the size of a facility and an increase in cost, a vacuum plasma processing apparatus including the same, and a method of cooling the plasma source.

The present invention provides a plasma source that is provided inside a vacuum chamber evacuated so that the inside becomes a vacuum state and constitutes a vacuum plasma processing apparatus along with the vacuum chamber, the plasma source comprising: a plasma generation electrode that generates plasma inside the vacuum chamber; and a reduced pressure space forming member that forms a reduced pressure space in a back surface of the plasma generation electrode, the reduced pressure space containing a liquid cooling medium and being capable of depressurizing; wherein the plasma generation electrode is cooled by evaporation heat generated when the cooling medium evaporates.

The present invention provides a vacuum plasma processing apparatus includes: a vacuum chamber of which the inside is evacuated to a vacuum state; and the plasma source, wherein the plasma source is provided inside the vacuum chamber.

The present invention provides a plasma source cooling method for a vacuum plasma processing apparatus including a vacuum chamber of which the inside is evacuated to a vacuum state and a plasma source which is provided inside the vacuum chamber and includes a plasma generation electrode for generating plasma inside the vacuum chamber, the plasma source cooling method including: forming a reduced pressure space at the back surface of the plasma generation electrode; and evaporating a liquid cooling medium inside the reduced pressure space and cooling the plasma generation electrode by the evaporation heat.

### BRIEF DESCRIPTION OF DRAWINGS

[Fig. 1] Fig. 1 is a view illustrating a vacuum plasma processing apparatus according to a first embodiment of the present invention.
[Fig. 2] Fig. 2 is a view illustrating a modified example of the vacuum plasma processing apparatus according to the first embodiment.
[Fig. 3] Fig. 3 is a view illustrating a modified example of the vacuum plasma processing apparatus according to the first embodiment.
[Fig. 4] Fig. 4 is a view illustrating a modified example of the vacuum plasma processing apparatus according to the first embodiment.
[Fig. 5] Fig. 5 is a view illustrating a vacuum plasma processing apparatus according to a second embodiment of the present invention.
[Fig. 6] Fig. 6 is a cross-sectional view taken along the line VI-VI of Fig. 5.
[Fig. 7] Fig. 7 is a view illustrating a modified example of the vacuum plasma processing apparatus according to the second embodiment.
[Fig. 8] Fig. 8 is a cross-sectional view taken along the line VIII-VIII of Fig. 7.
[Fig. 9] Fig. 9 is a view illustrating a modified example of a cooling device according to the second embodiment.
[Fig. 10] Fig. 10 is a view illustrating a vacuum plasma generation device according to a third embodiment of the present invention.
[Fig. 11] Fig. 11 is a view illustrating a structure of a condensing device illustrated in Fig. 10.
[Fig. 12] Fig. 12 is a view illustrating a vacuum plasma processing apparatus according to a fourth embodiment of the present invention.
[Fig. 13] Fig. 13 is a view illustrating a modified example of the vacuum plasma processing apparatus according to the fourth embodiment.
[Fig. 14] Fig. 14 is a view illustrating a modified example of the vacuum plasma processing apparatus according to the fourth embodiment.
[Fig. 15] Fig. 15 is a view illustrating a vacuum plasma processing apparatus according to a fifth embodiment of the present invention.
[Fig. 16] Fig. 16 is a cross-sectional view taken along the line XVI-XVI of Fig. 15.
[Fig. 17] Fig. 17 is a view illustrating a vacuum plasma generation device according to a sixth embodiment of the present invention.
[Fig. 18] Fig. 18 is a view illustrating a modified example of the vacuum plasma generation device according to the sixth embodiment.
[Fig. 19] Fig. 19 is a perspective view of a reservoir illustrated in Fig. 18 and a tube connected thereto.
[Fig. 20] Fig. 20 is a view illustrating a vacuum plasma generation device according to a seventh embodiment.

### DESCRIPTION OF EMBODIMENTS

Hereinafter, embodiments of the present invention will be described in detail with reference to the drawings.

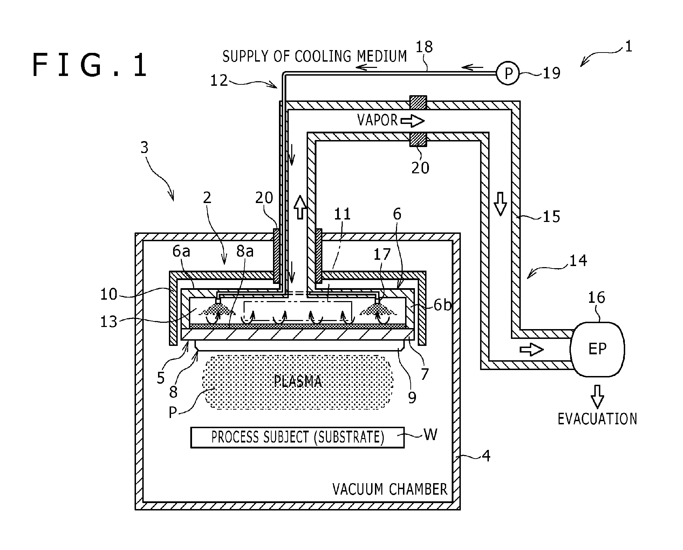

Fig. 1 illustrates an entire configuration of a vacuum plasma processing apparatus 3 according to the first embodiment of the present invention equipped with a cooling device 1. The vacuum plasma processing apparatus 3 includes a box-shaped vacuum chamber 4 that may evacuate the inside thereof in a vacuum state, a plasma source 2 that is provided inside the vacuum chamber 4 and includes a plasma generation electrode 8, and a vacuum pump (not illustrated) that is connected to the vacuum chamber 4. The vacuum pump evacuates the inside of the vacuum chamber 4 so that the inside becomes a vacuum state or an extremely low-pressure state. A substrate (a process subject) W such as a wafer, glass, and a film that corresponds to a plasma process subject is disposed inside the vacuum chamber 4, and the plasma source 2 is disposed so that the substrate W faces the plasma generation electrode 8. Power such as plasma generation power (DC (Direct Current), Pulse DC (Intermittent Direct Current), MF-AC (Alternating Current of Middle Frequency Band), or RF (High Frequency)) may be supplied from a plasma power supply (not illustrated) to the plasma source 2.

In the vacuum plasma processing apparatus 3, when the vacuum pump is operated so that the inside of the vacuum chamber 4 becomes a vacuum state, a discharge gas such as Ar is introduced into the vacuum chamber 4. Then, when the plasma power supply applies a potential to the plasma generation electrode 8 of the plasma source 2, plasma P is generated between the plasma generation electrode 8 and the substrate W.

In the description below, a description will be made mainly on the assumption that the vacuum plasma processing apparatus 3 is a sputtering device. However, the vacuum plasma processing apparatus of the present invention is not limited thereto. For example, the present invention may be applied to a vacuum plasma processing apparatus other than the sputtering device, that is, a device that performs a plasma CVD coating process or an etching process.

As illustrated in Fig. 1, the plasma source 2 is a sputter source in a case of the sputtering device, and includes a flat-plate-shaped casing 5 of which the inside is hollow. The casing 5 includes the plasma generation electrode 8 and a bottomed casing body 6 that is disposed so as to be opened toward the substrate W, and the plasma generation electrode 8 is formed in a plate shape that closes the opening of the casing body 6. The casing body 6 corresponds to a reduced pressure space forming member, and includes a rectangular or disk-shaped back wall 6a that is disposed so as to face the back surface 8a of the plasma generation electrode 8 and an external wall 6b that protrudes from the peripheral edge of the back wall 6a toward the back surface 8a of the plasma generation electrode 8. When the external wall 6b is bonded to the peripheral edge of the back surface 8a of the plasma generation electrode 8, that is, the plasma generation electrode 8 closes the opening of the casing body 6, the casing 5 is formed and a reduced pressure space 13 is formed therein so as to be air-tightly isolated from the space inside the external vacuum chamber 4.

The plasma generation electrode 8 includes a backing plate 7 and a target 9 as a coating material disposed on the surface the backing plate in a case where the plasma generation electrode is used as the sputter source. The target 9 is a sputtering target in a case of the sputtering device, and in many cases, the target 9 as the coating material is attached onto the backing plate 7.

The backing plate 7 is generally formed in a plate shape by metal, and in this embodiment, the backing plate is formed in a disk shape. As the metal, copper that is excellent in both thermal conductivity and electric conductivity is used in many cases, but SUS, aluminum, or the like may be also used. The target 9 is a coating material, and examples thereof include all metal material, an inorganic material such as C and Si, a transparent conductive film material such as ITO, a compound such as SiO₂ and SiN, an organic material, and all materials that may be formed in a plate shape. Further, for example, in a case where Cu or Ti is used as the target material, the target 9 may be directly used as a plasma generation electrode by removing the backing plate 7.

When plasma is generated on the plasma generation electrode 8, that is, the target 9, an ion such as Ar in the plasma is attracted to a negative potential of the plasma generation electrode so as to collide with the target 9 with high-energy, and atoms of the target 9 are sputtered by a sputtering phenomenon. The atoms are deposited as a coating on the substrate W, and hence a deposition process is performed in this way. Meanwhile, the energy of Ar colliding with the target 9 heats the target 9, and the heat is transmitted to the backing plate 7. As a result, the entire plasma generation electrode 8 is heated.

Furthermore, in a case where the vacuum plasma processing apparatus 3 is the plasma CVD apparatus or the etching apparatus, the target material is not provided and only the plasma generation electrode 8 is provided. Further, there is a case in which the substrate W is attached to the plasma generation electrode 8 in accordance with the type of device. In this case, the target of the plasma generation electrode does not evaporate as in the case of the sputtering device. However, plasma is generated in the vicinity of the plasma generation electrode 8, an ion or an electron having high energy in the plasma collides with the plasma generation electrode, and this energy heats the plasma generation electrode 8. This phenomenon is the same as that of the sputtering device.

In this embodiment, a dark space shield 10 that suppress the generation of the plasma P in a place other than the surface of the substrate W is disposed at the outside of the casing 5. The dark space shield 10 surrounds surfaces excluding the front surface in the entire surface of the plasma generation electrode 8 from the outside while maintaining a predetermined distance from the casing 5. In this way, when the outer surface of the casing 5 is physically covered, it is possible to prevent the generation of the plasma P on the surface of the casing 5 other than the plasma generation electrode 8.

For example, a magnetic field generation device 11 may be provided at a position indicated by the imaginary line inside the casing 5. The magnetic field generation device 11 generates a magnetic field in the vicinity of the surface of the plasma generation electrode 8 and facilitates the generation of the plasma P by the action of the magnetic field, thereby confining the plasma P. As the magnetic field generation device 11, for example, a magnetron magnetic field generation mechanism formed in a racetrack shape may be used.

As described above, a hollow portion that is the inner space of the casing 5 and is air-tightly isolated from the inside of the vacuum chamber 4 outside the casing 5 is formed at the back surface of the plasma generation electrode 8, and the hollow portion is formed as the reduced pressure space 13. The cooling device 1 according to this embodiment includes a cooling medium supply device 12 and an evacuation device 14 in addition to the casing body 6 which is the reduced pressure space forming member for forming the reduced pressure space 13.

The cooling medium supply device 12 supplies a liquid cooling medium to the inside of the casing 5 that is air-tightly isolated as described above, that is, the back surface (in this embodiment, the backing plate 7) of the plasma generation electrode 8. Here, according to the cooling system of the related art, the cooling medium is circulated to the back surface of the plasma generation electrode 8 so as to cool the backing plate 7. Thus, in this system, the backing plate 7 is not sufficiently cooled and the entire cooling efficiency for the backing plate 7 is not high as described above. On the contrary, in the cooling device 1 of the plasma source 2 of the vacuum plasma processing apparatus 3 according to this embodiment, the evacuation device 14 evacuates the reduced pressure space 13 inside the casing 5 so as to reduce the pressure therein. Accordingly, the evaporation of the liquid cooling medium supplied to the back surface 8a of the plasma generation electrode 8 is promoted, and the plasma generation electrode 8 is cooled by the evaporation heat generated when the cooling medium evaporates.

In this way, since the reduced pressure space 13 is formed in the back surface of the plasma generation electrode 8, that is, the inside of the casing 5, the cooling medium may be evaporated at the back surface of the plasma generation electrode 8, and hence the heat may be efficiently removed from the plasma generation electrode 8. Further, since both the front surface and the back surface of the plasma generation electrode 8 (the backing plate 7) becomes a reduced pressure state due to the reduced pressure of the reduced pressure space 13 inside the casing 5, the pressure difference between both surfaces is relatively small. Therefore, there is no need to prepare a sealing device with a high pressure capacity in order to seal the cooling medium inside the reduced pressure space 13. Further, since the pressure difference is small, the strength of any portions of the plasma source 2 can be designed at relatively small.

Next, the reduced pressure space forming member forming the cooling device 1 of the first embodiment, that is, the casing body 6, the evacuation device 14, and the cooling medium supply device 12 will be described in detail.

As illustrated in Fig. 1, the cooling device 1 of the first embodiment is provided so as to cool the flat-plate-shaped plasma source 2 that is disposed in the horizontal direction.

As described above, the reduced pressure space 13 that is surrounded by the casing body 6 and the plasma generation electrode 8 (the backing plate 7) is formed in the back surface of the plasma generation electrode 8 of the plasma source 2, and is air-tightly isolated from the inside of the vacuum chamber 4 or the outside of the casing 5. The evacuation device 14 includes an evacuation tube 15 and an evacuation pump 16 which are used to evacuate the inside of the reduced pressure space 13, and the evacuation tube 15 is connected to the upper portion of the casing 5. The evacuation pump 16 evacuates the inside of the reduced pressure space 13 through the evacuation tube 15, so that the pressure inside the reduced pressure space 13 is reduced to 20 kPa (0.2 atm) or less and desirably 4.2 kPa (about 0.04 atm) or less in a case where the cooling medium is water. 20 kPa corresponds to the vapor pressure of water of 60°C, 4.2 kPa corresponds to the vapor pressure of water of about 30°C, and the temperature of the plasma source 2 is controlled in response to the pressure of the reduced pressure space. Meanwhile, when the pressure of the reduced pressure space 13 is lower than about 0.6 kPa, there is a concern that the supplied water is cooled to a sub-zero temperature and is frozen. Accordingly, it is desirable that the evacuation device 14 keep the pressure inside the reduced pressure space 13 at about 0.6 kPa or more. In a case where the cooling medium is not water, the pressure is defined by the relation between the vapor pressure of the medium and the target cooling temperature. However, it is desirable that the pressure do not exceed 50 kPa in order to keep the merit of the strength of the plasma source 2.

As described above, the cooling medium supply device 12 supplies a liquid cooling medium into the reduced pressure space 13, and the supplied liquid cooling medium is heated and evaporated by the plasma generation electrode 8 of the plasma source 2, thereby generating the vapor of the cooling medium.

The evacuation tube 15 of the evacuation device 14 is installed so as to guide the vapor of the cooling medium from the reduced pressure space 13 to the outside of the vacuum chamber 4. The evacuation pump 16 is operated so that the vapor of the cooling medium is suctioned through the evacuation tube 15. The evacuation tube 15 is formed as a tubular member that may circulate the vapor or the liquid cooling medium. One end of the evacuation tube 15 is opened to the upper inner wall surface of the casing 5, and is installed so that the vapor of the cooling medium is evacuated from the inside of the casing 5 to the outside of the vacuum chamber 4.

As the evacuation pump 16, it is desirable to use an ejector pump capable of ejecting not only the vapor of the cooling medium, but also the liquid cooling medium. For example, in a case where the cooling medium is water, a pump such as a water ejector pump or a vapor ejector pump capable of ejecting water and vapor in a mixed state may be used as the evacuation pump 16.

In this embodiment, the cooling medium supply device 12 that supplies a cooling medium to the back surface 8a of the plasma generation electrode 8 includes a plurality of nozzles 17 as a cooling medium spraying portion, a supply tube 18, and a cooling medium supply pump 19. The nozzles 17 spray the liquid cooling medium to the back surface 8a of the plasma source 2 and the cooling medium is uniformly supplied to the entire surface of the back surface 8a. The plurality of nozzles 17 are disposed in the back wall 6a, that is, the flat-shaped upper portion of the casing 5. The supply tube 18 is installed so as to distribute the liquid cooling medium to the nozzles 17. The cooling medium supply pump 19 is operated so as to pressure-feed the liquid cooling medium to the nozzles 17 through the supply tube 18.

In this way, since the cooling medium supply device 12 sprays the liquid cooling medium to the entire surface of the back surface 8a of the backing plate 7 so that the cooling medium is uniformly dispersed on the entire surface of the back surface 8a of the plasma generation electrode 8, the plasma source 2 can be cooled efficiently and uniformly.

Since the evacuation tube 15 of the evacuation device 14 is electrically connected to the plasma source 2, the evacuation tube 15 and the vacuum chamber 4 have different potentials. Thus, an electric insulation portion 20 may be disposed therebetween. As such an electric insulation portion 20, a member that is formed of an inorganic material such as ceramics or glass or a synthetic resin without conductivity is desirably used, and the member is desirably provided between the evacuation tube 15 of the evacuation device 14 and the vacuum chamber 4. In the drawings, the electric insulation portion 20 is provided between the evacuation tube 15 and the dark space shield 10 or between the evacuation tube 15 and the evacuation tube support member in addition to the position between the evacuation tube 15 and the vacuum chamber 4. The arrangement of the electric insulation portion 20 can prevent the generation of the plasma P in the periphery of the dark space shield 10 or the electrical shock caused by the contacting the evacuation tube 15 or the evacuation pump 16 connected to the evacuation tube 15. Further, when a part of the evacuation tube 15 is formed by the electric insulation member, it is possible to prevent a current from flowing to the evacuation pump 16. In this way, it is desirable to dispose an appropriate electric insulation portion in the cooling medium supply tube 18 or a drain 21 to be described later.

Next, a method of cooling the plasma source 2 using the cooling device 1, that is, a cooling method of the present invention will be described.

Hereinafter, a case of a sputtering deposition process will be described. In the sputtering deposition process, for example, the flat-plate-shaped plasma source 2 (the sputter source) and the substrate W are disposed so as to be parallel to each other in the horizontal direction. After the inside of the vacuum chamber 4 is evacuated to the vacuum state, a plasma generation gas (for example, Ar) is supplied into the vacuum chamber 4, and a potential is applied from a plasma power supply to the plasma source (the sputter source) 2, so that the plasma P is generated in the vicinity of the plasma generation electrode 8 of the plasma source 2.

When the plasma P is generated, a large amount of heat is generated in the front surface (that is, the target 9) of the plasma generation electrode 8. In order to cool the plasma generation electrode 8, the cooling medium supply device 12 supplies a liquid cooling medium into the reduced pressure space 13 while the evacuation device 14 evacuates the reduced pressure space 13. In this embodiment, the supply of the liquid cooling medium is performed by the spraying of the liquid cooling medium from the nozzles 17, so that the cooling medium is supplied so as to be uniformly dispersed in the entire surface of the back surface 8a of the plasma generation electrode 8. The liquid cooling medium that is supplied so as to be dispersed in the entire surface of the back surface 8a of the plasma generation electrode 8 in this way evaporates while absorbing the heat transmitted to the back surface 8a of the plasma generation electrode 8 (the backing plate 7) as the evaporation heat. When the evaporation heat is robbed in this way, the plasma source 2 including the plasma generation electrode 8 is cooled. The vapor of the cooling medium that evaporates from the back surface 8a is suctioned into the evacuation pump 16 outside the vacuum chamber 4 through the evacuation tube 15 of the evacuation device 14. That is, the inside of the reduced pressure space 13 is evacuated by the evacuation pump 16.

In this way, since the back surface 8a of the plasma source 2 of the plasma generation electrode 8 is provided with the reduced pressure space 13 capable of performing the vacuum evacuation, the evaporation of the cooling medium supplied to the back surface 8a is promoted, and the plasma generation electrode 8 can be efficiently cooled (evaporation-cooled) by using the evaporation heat of the cooling medium. Particularly, in a case where such an evaporation-cooling is used, the loss of a heat transfer caused by a fluid film like the cooling medium circulation system does not occur. Further, since the casing 5 is formed by the plasma generation electrode 8 and the casing body 6 and the inside thereof is formed as the reduced pressure space 13, the pressure difference between the front surface and the back surface 8a of the plasma generation electrode 8 may be largely reduced. In this configuration, there is no need to increase the thickness of the backing plate 7 for the allowable strength or there is no need to use the sealing device having high pressure capacity for the sealing of the liquid cooling medium. Accordingly, the plasma source 2 including the plasma generation electrode may be uniformly cooled without any variation by the use of a simple facility. Further, since the required strength is reduced, the apparatus can be simplified, and hence the flexibility for the design of the plasma source 2 can be improved.

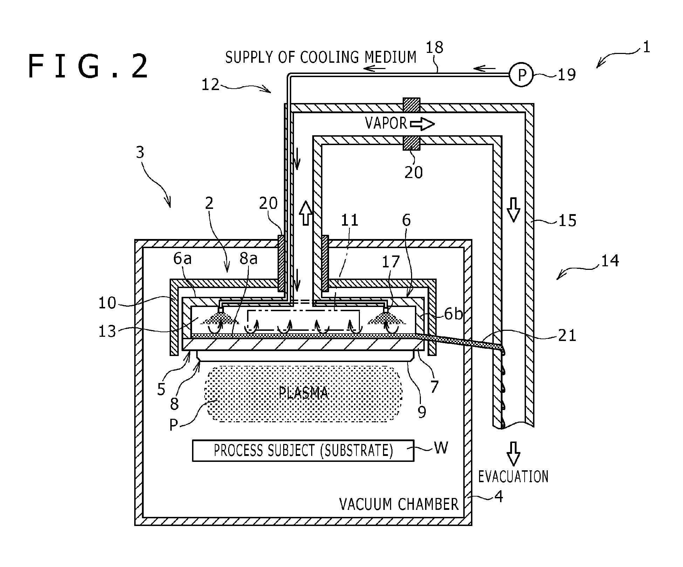

The cooling device 1 of the first embodiment may be provided with a drain that derives both the vapor of the cooling medium and the liquid cooling medium from the reduced pressure space 13 to the evacuation tube 15. For example, the drain corresponds to a drain tube 21 illustrated in Fig. 2. For example, one end of the drain tube 21 is fixed to the casing body 6 so as to be opened to the inside of the casing 5, and the other end of the drain tube 21 is fixed to the evacuation tube 15 so as to be opened to the inside of the evacuation tube 15. Here, the position of the other end is set to be lower than the position of one end. The cooling medium which is not evaporated and is left inside the reduced pressure space 13 may be discharged through the drain tube 21, and hence it is possible to prevent the redundant cooling medium from disturbing the evaporation-cooling operation.

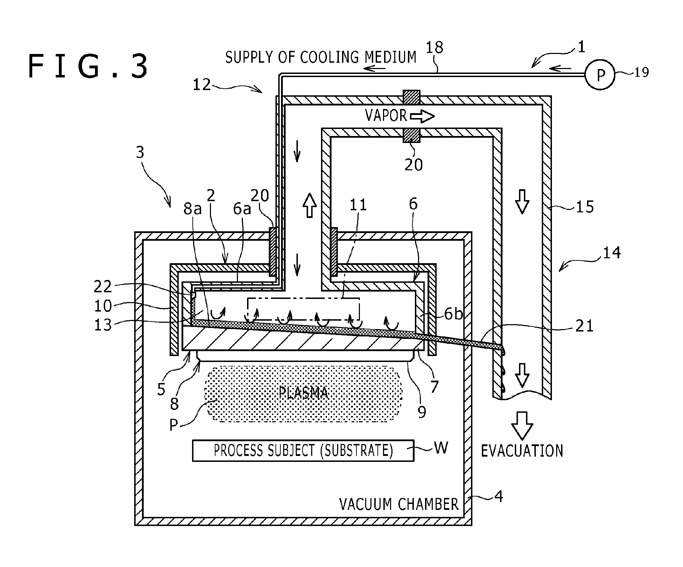

The back surface 8a of the plasma source 2 of the plasma generation electrode 8 may be inclined instead of a horizontal state. For example, in a case where the back surface 8a of the plasma generation electrode 8 is inclined as illustrated in Fig. 3, it is desirable that the cooling medium supply device 12 supply the liquid cooling medium to the high portion in the back surface 8a, that is, the left portion in Fig. 3 so that the cooling medium is uniformly dispersed in the entire surface of the back surface 8a by the action of gravity. The liquid cooling medium that is supplied in this way flows and falls to the low portion, that is, the right portion in Fig. 3 along the back surface 8a inclined as described above. In this way, since the liquid cooling medium may be uniformly dispersed in the entire surface of the back surface 8a by the action of gravity, the plasma source 2 may be efficiently cooled.

In a case where the liquid cooling medium is uniformly dispersed in the entire surface of the back surface 8a by the action of gravity in this way, the cooling medium supply device 12 may supply the cooling medium to the back surface 8a while being dropped along the wall surface instead of the nozzle 17. That is, the cooling medium supply device 12 includes a dropping portion 22 that drops the cooling medium to the inner wall surface of the casing 5 contacting the high portion in the inclined back surface 8a of the plasma generation electrode 8, and may drop the cooling medium along the side wall surface of the casing 5 from the dropping portion 22. In this way, the cooling medium that is dropped from the dropping portion 22 reaches the back surface 8a while being transmitted to the side wall surface of the casing 5, and flows down along the inclined back surface 8a. Accordingly, the liquid cooling medium may be uniformly dispersed in the entire surface of the back surface 8a, and hence the evaporation of the cooling medium is promoted.

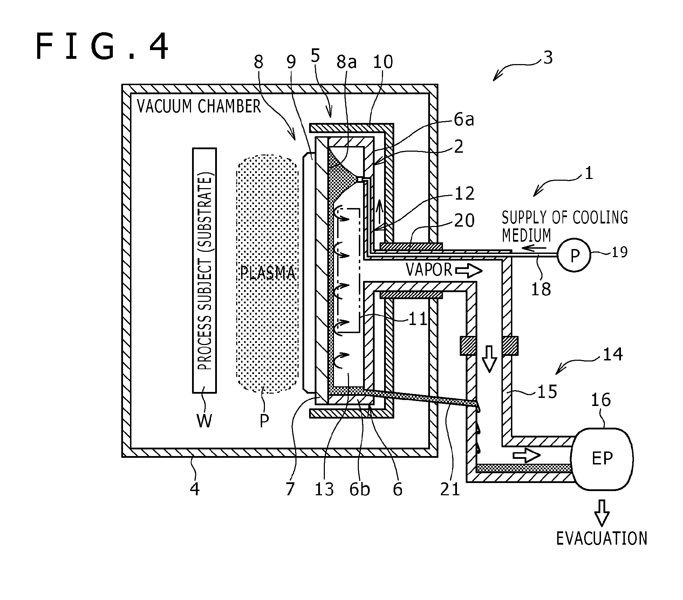

Figs. 1 to 3 illustrate examples in which the plasma source 2 is disposed in the horizontal direction, but as illustrated in the example of Fig. 4, the plasma source 2 may be disposed in the vertical direction in the vacuum plasma processing apparatus according to the present invention. In this way, in a case where the plasma source 2 is disposed in a standing state in the vertical direction, the inclination of the back surface 8a of the plasma generation electrode 8 may be set to be larger than that of Fig. 3. For example, as illustrated in Fig. 4, the back surface may be formed as a vertical surface. Accordingly, it is possible to further improve the effect in which the liquid cooling medium is uniformly dispersed in the entire surface of the back surface 8a by the action of gravity.

For example, the drain, that is, the drain tube 21 that causes the inside of the casing 5 to communicate with the evacuation tube 15 as illustrated in Fig. 2 may be also applied to the apparatuses illustrated in Figs. 3 and 4. By this application, the redundant cooling medium accumulated in the low portion of the back surface 8a may be discharged.

When the cooling medium supply device 12 that disperses the cooling medium in the entire surface of the back surface 8a using the action of gravity is used as illustrated in Figs. 3 or 4, the liquid cooling medium is uniformly distributed in the entire surface of the back surface 8a, and hence the evaporation of the cooling medium may be performed in the entire surface without any variation. Accordingly, the electrode may be further efficiently cooled.

In the above-described device, the cooling medium may be dispersed in the entire surface of the back surface 8a by the use of the capillary action. For example, although not illustrated in the drawings, the back surface 8a of the plasma generation electrode 8 may be provided with a groove that guides the cooling medium so that the liquid cooling medium is uniformly dispersed in the entire surface of the back surface 8a by the capillary action. When the back surface 8a is provided with the groove that guides the liquid cooling medium by the capillary action, the liquid cooling medium is uniformly dispersed in the entire surface of the back surface 8a, and hence the plasma source 2 may be further efficiently cooled. The groove that guides the cooling medium may be directly formed in the back surface 8a of the plasma source 2 of Figs. 1 and 2. Alternatively, a structure other than the groove, for example, a mesh-shaped object may be provided in the back surface 8a of the plasma generation electrode 8, and the liquid cooling medium may be dispersed by the capillary action.

Next, the vacuum plasma processing apparatus 3 according to a second embodiment of the present invention will be described.

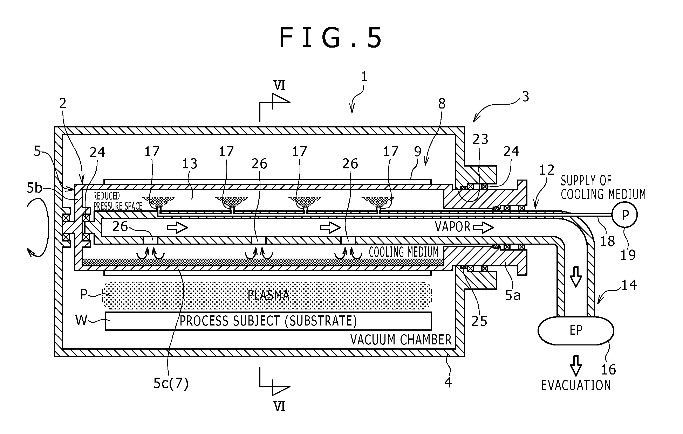

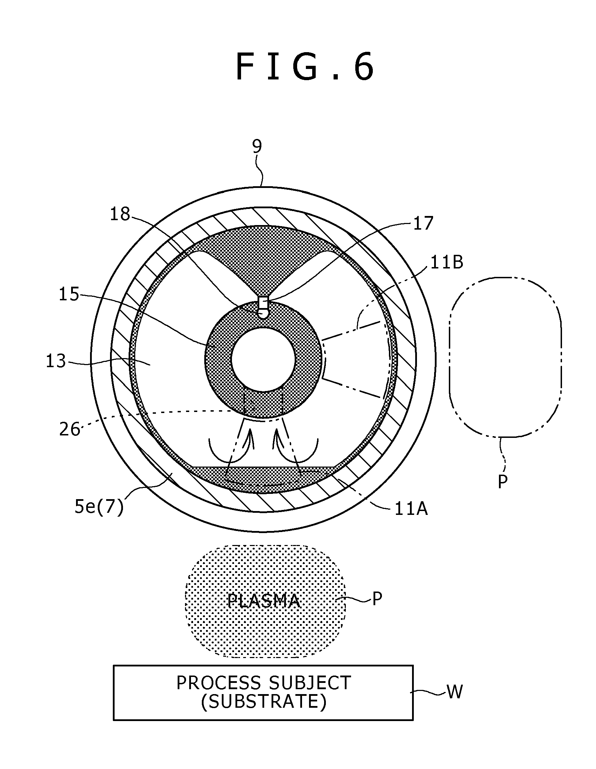

As illustrated in Figs. 5 and 6, the vacuum plasma processing apparatus 3 includes the vacuum chamber 4, the plasma source 2 that includes a cylindrical external wall having therein the reduced pressure space 13, the cooling device 1 that cools the plasma source, the cooling medium supply device 12, the evacuation device 14, and a rotational driving device that rotates the casing 5 of the plasma source 2 as described below, and at least the outer portion of the cylindrical external wall in the plasma source 2 forms the plasma generation electrode 8. The plasma source 2 is formed as a cylinder that is disposed so as to be rotatable about the horizontal axis.

Hereinafter, the plasma source 2 and the cooling device 1 formed in the electrode of the second embodiment will be described in detail. In the description below, a description will be made on the assumption that the plasma source 2 is a sputter source, that is, a so-called rotary magnetron sputter source with a cylindrical rotation target.

The side wall of the vacuum chamber 4 is provided with a circular opening portion 23. One end of the plasma source 2 (the rotary magnetron sputter source) forms a journal portion 5a, and the other portion of the plasma source 2 is accommodated inside the vacuum chamber 4 while the journal portion 5a protrudes toward the outside of the vacuum chamber 4 through the opening portion 23. Specifically, the plasma source 2 includes the casing 5 with a cylindrical external wall 5c and the journal portion 5a, and for example, the casing 5 is inserted from the opening portion 23 into the vacuum chamber 4, so that the plasma source 2 is assembled to the vacuum chamber 4. Further, the rotational driving device includes, for example, a motor and a driving transmission mechanism that connects the motor to the casing 5, and is connected to the casing 5 so that the casing 5 rotates about the axis of the external wall 5c.

A gap between the outer peripheral surface of the journal portion 5a of the plasma source 2 and the inner peripheral surface of the portion surrounding the opening portion 23 in the vacuum chamber 4 is provided with a bearing portion 24 that supports the casing 5 including the cylindrical external wall 5c so that the casing is rotatable about the horizontal axis with respect to the vacuum chamber 4 and a sealing portion 25 that keeps the air-tightness of the inside of the vacuum chamber 4 without disturbing the rotation of the casing 5 with respect to the vacuum chamber 4. Even in the second embodiment, there is a need to apply a plasma generation potential to the rotating casing 5 as in the first embodiment. Accordingly, although not illustrated in the drawings, an electric insulation portion is formed in any one of the chamber-side portion or the casing-side portion of the bearing portion 24.

The main portion of the external wall 5c of the casing 5 forms the plasma generation electrode 8 for generating plasma, and the other portion of the casing 5, for example, the journal portion 5a or the opposite end wall 5b corresponds to the reduced pressure space forming member of the present invention. As in the first embodiment, the plasma generation electrode 8 includes a backing tube 7 and the target 9 attached thereto. However, the backing tube 7 is formed by the main portion of the external wall 5c of the casing 5, and is disposed on the outer peripheral surface of the backing tube of the target 9.

In a case of the rotary magnetron sputtering, the magnetic field generation device is fixed into the plasma generation electrode as indicated by the two-dotted chain line of Fig. 6. The magnetic field generation device 11 selectively generates a racetrack-shaped magnetic field in a place where a racetrack-shaped magnetron magnetic field is formed in the front surface of the target 9. In the example of Fig. 6, the magnetic field generation mechanism is attached downward, for example, as indicated by the two-dotted chain line 11A of Fig. 6, the plasma is generated only in the lower portion of the plasma generation electrode 8, and the sputtering evaporation occurs at that position. On the other hand, since the plasma generation electrode 8 including the cylindrical target 9 rotates and the sputtering position of the target 9 by the plasma sequentially changes, the sputtering evaporation occurs in the entire circumference of the target 9.

The evacuation device 14 reduces the pressure of the reduced pressure space 13 inside the casing 5 of the plasma source 2. The pressure of the reduced pressure space 13 is different depending on the type of cooling medium in use. However, in a case where the cooling medium is water, the pressure is desirably 0.6 to 20 kPa as described in detail in the first embodiment.

With regard to the cooling medium supply device 12 and the evacuation device 14, these main portions are formed inside the casing 5 of the plasma source 2. The cooling medium supply device 12 supplies the liquid cooling medium to the inner peripheral surface of the plasma generation electrode 8, and the evacuation device 14 evacuates the vapor of the cooling medium supplied by the cooling medium supply device 12 from the inside of the casing 5.

The evacuation device 14 includes the evacuation tube 15, and the evacuation tube 15 is disposed inside the casing 5 including the cylindrical external wall 5c so as to follow the axis of the casing 5. Of course, the evacuation tube 15 has an outer diameter smaller than the inner diameter of the casing 5 of the plasma source 2. The evacuation tube 15 is disposed so as to uniformly depressurize the inner space of the casing 5 including the cylindrical external wall 5c, but the evacuation tube 15 may not be provided.

The cooling medium supply device 12 includes a supply pump (not illustrated), the supply tube 18, and the plurality of nozzles 17 as the cooling medium spraying portion, and the supply tube 18 includes a portion that extends in the axial direction inside the tube wall of the evacuation tube 15. The supply pump is disposed outside the vacuum chamber 4 and supplies the liquid cooling medium into the supply tube 18. The nozzles 17 are used to spray the liquid cooling medium supplied into the supply tube 18, and are disposed at an interval, for example, the same interval in the axial direction of the cylindrical plasma generation electrode 8. The nozzles 17 protrude outward (upward in the example of the drawing) from the supply tube 18, and may spray the liquid cooling medium toward the inner surface of the cylindrical plasma generation electrode 8. Meanwhile, since the cylindrical plasma generation electrode (the target) 8 rotates, the uniform supply of the cooling medium to the inner surface of each plasma generation electrode 8 is realized by the uniformly divided arrangement (distributed arrangement) of the nozzles 17 in the axial direction and the rotation in the circumferential direction.

The spraying directions of the nozzles 17 are not particularly set. However, in a case where the rotation shaft is provided in the horizontal direction, it is desirable that the spraying direction be set to an upward direction from the viewpoint of the effect in which the cooling medium flows down along the inner surface of the cylinder. In particularly, the cooling medium supply position is not particularly set in a case where the rotation shaft of the casing 5 including the cylindrical external wall 5c is horizontal as long as the cooling medium is supplied into the cylinder. When the rotation shaft of the casing 5 including the cylindrical external wall 5c is horizontal, the supplied cooling medium forms a substantially uniform reservoir at the lower side of the casing 5. Since the casing 5 rotates while the liquid cooling medium adheres to the inner peripheral surface and the cooling medium is lifted along the rotating casing 5, the liquid cooling medium that is accumulated at the lower side of the casing 5 becomes a film on the inner peripheral surface of the casing 5 so as to be uniformly coated thereon.

Even the evacuation device 14 of the second embodiment includes the evacuation tube 15 and the evacuation pump 16 as in the first embodiment. The evacuation tube 15 is installed so as to guide the vapor of the cooling medium from the reduced pressure space 13 inside the casing 5 to the outside of the vacuum chamber 4, and the evacuation pump 16 is operated so as to suction the vapor of the cooling medium through the evacuation tube 15.

The evacuation device 14 of the second embodiment is different from that of the first embodiment in that the evacuation tube 15 is fixed so as not to rotate and the rotation of the casing 5 disposed at the outside thereof is allowed. Specifically, the evacuation tube 15 according to the second embodiment is disposed inside the casing 5 including the cylindrical external wall 5c so as to be coaxial with the casing 5, the end (the left end in the drawings) opposite to the opening portion 23 in the end is closed, and the bearing portion 24 that allows the relative rotation of the casing 5 with respect to the evacuation tube 15 is provided between the closed end and the end wall 5b of the casing 5.

In the end of the evacuation tube 15, the end (the right end in the drawings) near the opening portion 23 extends horizontally to the outside of the vacuum chamber 4, and is connected to the evacuation pump 16provided outside the casing 5. The bearing portion 24 and the sealing portion 25 are disposed between the outer peripheral surface of the evacuation tube 15 and the inner peripheral surface of the journal portion 5a of the casing 5, and the bearing portion 24 allows the relative rotation of the casing 5 with respect to the evacuation tube 15 while the sealing portion 25 keeps the air-tightness of the inside of the casing 5. From such a viewpoint, it is desirable that the magnetic field generation device 11 disposed inside the casing be supported by the evacuation tube 15.

As illustrated in Figs. 5 and 6, a portion of the evacuation tube 15 that extends horizontally inside the casing 5 includes a plurality of intake ports 26, and the intake ports 26 are formed at a plurality of positions arranged in the axial direction. There is a case in which a pressure gradient occurs in response to the distance from the evacuation pump inside the evacuation tube 15. When this pressure gradient is taken into consideration, it is desirable that the intake port 26 have, for example, the larger opening diameter as it goes away from the evacuation pump.

Even in the plasma source 2 that includes the cylindrical external wall 5c according to the second embodiment, the back surface, that is, the inner surface of the cylindrical plasma generation electrode 8 is provided with the reduced pressure space 13 capable of performing a vacuum-evacuation. Furthermore, when the liquid cooling medium is supplied to the inner surface of the plasma generation electrode 8, the plasma source 2 may be effectively cooled by the use of the evaporation heat of the cooling medium.

Since even the plasma source 2 according to the second embodiment forms therein the reduced pressure space 13, the pressure difference generated between the outside (the front surface side) and the inside (the back surface side) of the plasma generation electrode 8 may be largely reduced. Due to the reduction of the pressure difference, there is no need to increase the thickness of the casing 5 or to use the sealing device having high pressure capacity for sealing the cooling medium. Accordingly, it is possible to effectively cool the plasma source 2 without any variation by the use of a simple facility.

Further, as described above, the rotation of the casing 5 during the supply of the liquid cooling medium enables the uniformly supply of the cooling medium to the inner surface of the plasma generation electrode 8 together with the uniform arrangement, that is, the distributed arrangement of the cooling medium spraying portions (in the second embodiment, the nozzles 17) along the rotation shaft. Further, when the rotation shaft is horizontal, the liquid cooling medium that is accumulated at the lower side of the casing 5 with the rotation of the casing 5 may be uniformly coated and dispersed on the inner peripheral surface, and hence the plasma source 2 may be further uniformly cooled without any variation.

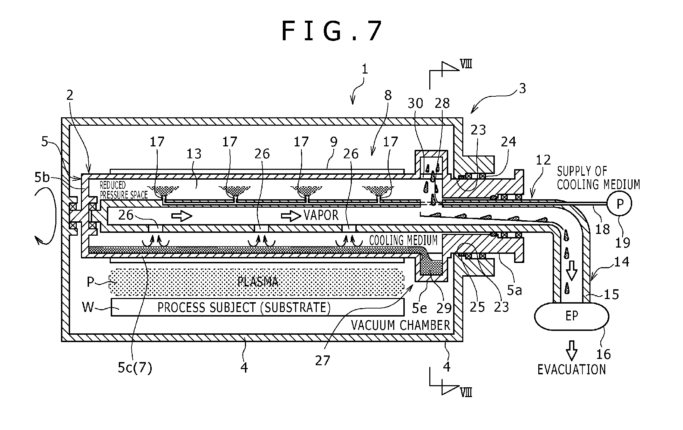

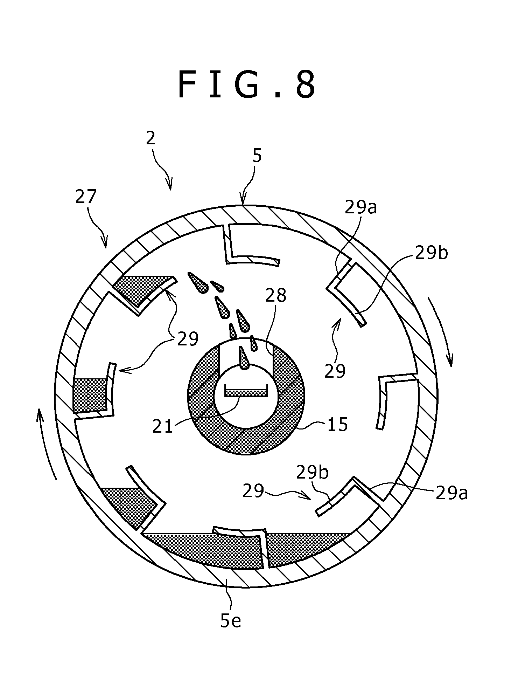

Even in the plasma source 2 according to the second embodiment, in a case where a large amount of the liquid cooling medium is accumulated inside the casing 5 so that the cooling operation is not easily performed, the liquid cooling medium that is accumulated inside the casing 5 may be discharged to the outside of the casing 5 by the use of the unit illustrated in Figs. 7 and 8.

The evacuation device 14 of the vacuum plasma processing apparatus 3 illustrated in Figs. 7 and 8 is further equipped with the drain 21 that derives the liquid cooling medium condensed and accumulated in the reduced pressure space 13 to the evacuation tube 15 and a pumping portion 27 that pumps the liquid cooling medium to the drain 21 in addition to the evacuation tube 15 and the evacuation pump 16.

The drain 21 is a gutter-shaped member which is disposed inside the evacuation tube 15 and through which the liquid cooling medium flows. The drain 21 is disposed so as to be slightly inclined with respect to the horizontal direction. Specifically, the drain is disposed so as to be inclined downward as it goes toward the outside of the casing 5, and the liquid cooling medium flows along the gradient. The drain 21 is formed in a gutter shape that is opened upward so that the liquid cooling medium flows thereinto from the upside thereof. Further, a portion of the evacuation tube 15 that is located above the drain 21 is provided with an inlet 28 into which the liquid cooling medium pumped by the pumping portion 27 flows.

The pumping portion 27 includes a plurality of drawing portions 29 that are formed in a bulging portion 5e as a part of the casing 5 as illustrated in Fig. 8. In this embodiment, the bulging portion 5e is formed at a position adjacent to the inside of the journal portion 5a, and has a shape that bulges outward in the radial direction in relation to the other portion. In other words, the bulging portion has a shape in which the inner peripheral surface thereof is recessed outward in the radial direction in relation to the inner peripheral surface of the other portion. The drawing portions 29 are formed at a plurality of parallel positions in the circumferential direction of the bulging portion 5e and are formed in a shape in which the liquid cooling medium entering the bulging portion 5e may be drawn. Specifically, each drawing portion 29 includes a partition wall 29a that protrudes from the inner peripheral surface of the bulging portion 5e inward in the radial direction so as to divide a space inside the bulging portion 5e and an auxiliary wall 29b that extends from the inner end of each partition wall 29a in the radial direction in the circumferential direction about the casing 5, and each auxiliary wall 29b prevents the overflow of the liquid cooling medium drawn by each partition wall 29a. In the pumping portion 27, the liquid cooling medium that is accumulated at the lower side of the casing 5 flows to the drawing portion 29 located at the lowest position, and is pumped by the drawing portion 29. Each drawing portion 29 is disposed so that only an area between the auxiliary wall 29b and the partition wall 29a of the drawing portion 29 adjacent thereto is opened toward the evacuation tube 15, and has a shape in which the drawn cooling medium may be accommodated therein in a non-flow state. The drawing portions 29 rotate while drawing a circular orbit around the evacuation tube 15 in accordance with the rotation of the casing 5 (by using the rotational driving force as a power source). Accordingly, when the drawing portion 29 is located at the uppermost portion of the circular orbit, the opened portion faces downward so that the liquid cooling medium drops.

The pumping portion 27 illustrated in Figs. 7 and 8 may efficiently cool the plasma source 2 without any variation by discharging the redundant liquid cooling medium to the outside of the casing 5 even when a large amount of the liquid cooling medium is accumulated inside the casing 5.

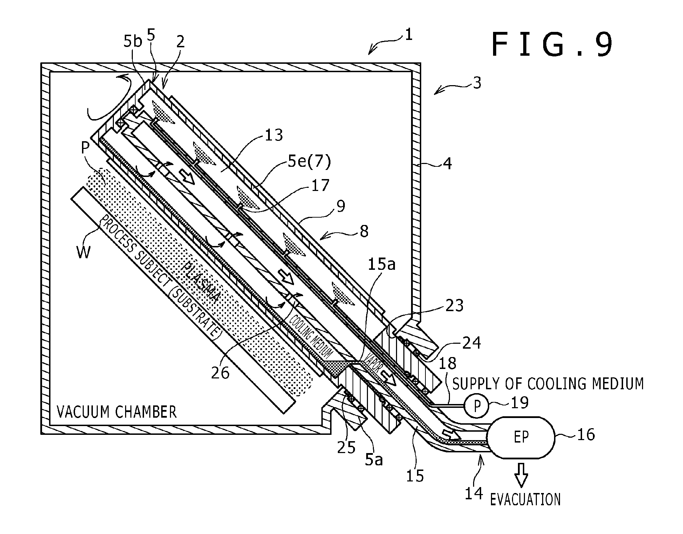

In the cooling device 1 of the second embodiment, the plasma source 2 that includes the cylindrical external wall 5c is disposed so that the axis thereof faces the horizontal direction, but the axis may be disposed in the inclined direction or the perpendicular direction. The plasma source 2 illustrated in Fig. 9 includes the casing 5 with the cylindrical external wall 5c and is disposed so as to be rotatable about the axis thereof while the axis thereof faces the inclined direction.

In this way, in a case where the casing 5 of the plasma source 2 is disposed in an inclined posture, the liquid cooling medium supplied into the casing 5 flows downward along the inner peripheral surface of the casing 5. Then, the redundant liquid cooling medium is accumulated in the lower portion of the casing 5. Thus, even in this case, when a drain is provided so as to discharge the redundant cooling medium accumulated at the lowest position inside the casing 5 to the evacuation tube 15, the redundant liquid cooling medium is discharged to the outside of the casing 5 even when the complex pumping portion 27 illustrated in Figs. 7 and 8 is not provided, and hence the plasma source 2 may be efficiently cooled without any variation. For example, in the example illustrated in Fig. 9, a communication hole 15a that is used for the communication between the inside and the outside of the evacuation tube 15 is formed in a portion adjacent to a portion where the redundant cooling medium is accumulated in the evacuation tube 15, and the redundant cooling medium is discharged along the communication hole 15a and the inside of the upstream evacuation tube 15. Although not illustrated in the drawings, the same applies to the case where the casing 5 is disposed so that the axis thereof faces the perpendicular direction.

As described above, even the inside of the casing 5 according to the second embodiment may be provided with the magnetic field generation device 11 as in the first embodiment. In this case, the magnetic field generation device 11 may be disposed at, for example, the position indicated by the two-dotted chain line 11B, that is, the lateral position of the evacuation tube 15 other than the position indicated by the two-dotted chain line 11A illustrated in Fig. 6, that is, the lower position of the evacuation tube 15. The position may be set in accordance with the position where the plasma P needs to be generated.

While the second embodiment has been described by exemplifying a case in which the plasma source 2 including the cylindrical external wall 5c is the rotary magnetron sputter source, but the present invention may be also applied to a plasma CVD apparatus or an etching apparatus. For example, there is known a plasma CVD apparatus disclosed in JP 2008-196001 A. The plasma CVD apparatus includes a rotational cylindrical electrode as a plasma source, a film substrate is wound on the front surface thereof, and a coating is formed on the substrate while the film substrate is conveyed in a vacuum state along with the rotation of the cylindrical electrode. Even in this apparatus, the rotational cylindrical electrode may be cooled. This apparatus and the apparatus including the rotary magnetron sputter source are different in that the plasma generation electrode is not a target material and does not evaporate, the substrate has a film shape and is wound on the plasma generation electrode, and a plasma CVD method of decomposing a source gas by plasma and depositing the coating on the film is used instead of the sputtering method. However, since the plasma source including the rotational cylinder is provided inside the vacuum chamber, the energy of the generated plasma needs to be transmitted to the rotating cylindrical plasma generation electrode through the film substrate so that the plasma source is cooled. Further, since the magnetic field generation device is also provided therein so as not to be rotatable, the basic structure is the same as that of the rotary magnetron sputter source. Accordingly, the cooling device of the present invention may be effectively applied thereto.

Next, the plasma source 2 and the vacuum plasma processing apparatus with the same according to a third embodiment will be described.

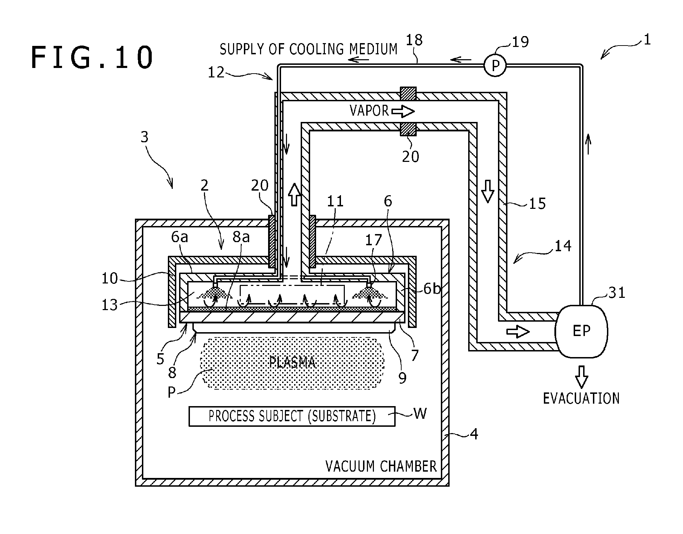

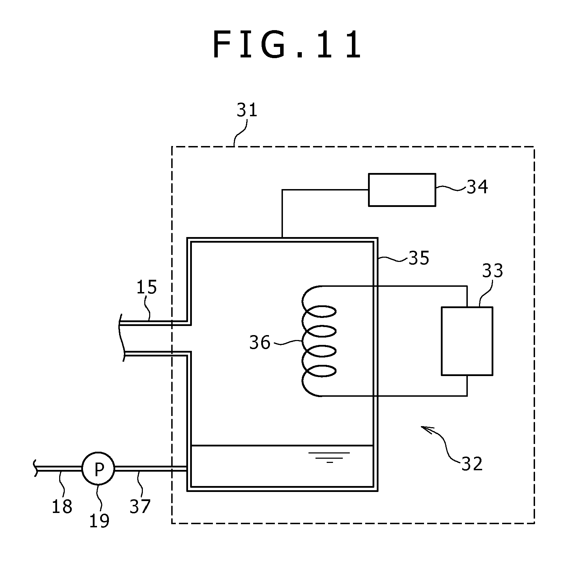

As illustrated in Figs. 10 and 11, the apparatus according to the third embodiment includes a condensing device 31 instead of the evacuation pump 16 of the first embodiment. The other configurations are substantially the same as those of the first embodiment. Therefore, the configuration of the condensing device 31 will be described in detail below.

As illustrated in Fig. 10, the plasma source 2 includes the flat-plate-shaped casing 5 in which the reduced pressure space 13 is formed inside a hollow portion as in the first embodiment, and the casing 5 includes the plasma generation electrode 8 and the casing body 6. The evacuation tube 15 that evacuates the reduced pressure space 13 inside the casing is connected to the upper side of the casing 5. The evacuation tube 15 is connected to the condensing device 31 that is provided outside the vacuum chamber 4.

One end of the evacuation tube 15 is opened to the inner wall surface of the back wall 6a of the casing body 6 so that the vapor of the cooling medium is evacuated from the inside of the casing 5 to the outside of the vacuum chamber 4, and the other end thereof is connected to the condensing device 31 so that the discharged vapor of the cooling medium is introduced into the condensing device 31.

Specifically, as illustrated in Fig. 11, the condensing device 31 includes a condenser 32 and an auxiliary depressurizing portion 34.

The condenser 32 includes a condensing chamber 35, a heat exchanging portion 36 that is provided therein, and a cooling system 33 that is provided outside the condensing chamber 35, and the evacuation tube 15 is connected to the condensing chamber 35. For example, the heat exchanging portion 36 is formed as a cooling coil, and the cooling medium circulates between the inside thereof and the cooling system 33. The cooling system 33 causes the circulated cooling medium to exchange heat with the cooling source so that the temperature of the cooling medium becomes low, and sends the cooling medium to the heat exchanging portion 36. As the cooling system 33, a cooling tower or a chiller is employed. The heat exchanging portion 36 may be configured as a shell and tube type and a plate type instead of the cooling coil type illustrated in the drawings. Alternatively, as a member that cools the wall surface of the condensing chamber 35, the condensing chamber 35 may be used as the heat exchanging portion. The cooling medium supplied to the plasma source may be the same as the cooling medium supplied from the cooling system 33 to the heat exchanging portion 36. In that case, the vapor of the cooling medium may be condensed by causing the medium to exchange heat with the vapor of the cooling medium flowing from the evacuation tube 15 into the condensing chamber 35 in a manner such that the medium supplied from the cooling system 33 is directly showered or sprayed into the condensing chamber 35.

A transportation tube 37 is connected to the bottom portion of the condensing chamber 35. The transportation tube 37 is installed so that the cooling medium that is condensed and liquefied inside the condensing chamber 35 is derived to the outside of the condensing chamber 35 and is transported to the cooling medium supply pump 19. The cooling medium that is returned to the cooling medium supply pump 19 through the transportation tube 37 is introduced again into the reduced pressure space 13 of the plasma source 2 through the supply tube 18, and is used to cool the plasma source 2.

The auxiliary depressurizing portion 34 is used to depressurize a space from the reduced pressure space 13 to the condensing chamber 35 of the condenser 32 through the inside of the evacuation tube 15 by evacuating the inside of the condensing chamber 35. As the auxiliary depressurizing portion 34, for example, a vacuum pump is desirable. It is desirable that the evacuation capability of the auxiliary depressurizing portion 34 be lower than the evacuation capability of the evacuation pump 16 according to the first embodiment. Specifically, the auxiliary depressurizing portion may be just used to auxiliary evacuate the inside of the condensing chamber 35.

Next, the operation of the condensing device 31 will be described.

As in the first embodiment, a case will be described in which the sputtering deposition process is performed by generating the plasma P in the vicinity of the plasma generation electrode 8 of the plasma source 2. When the plasma P is generated, a large amount of heat is generated in the front surface of the plasma generation electrode 8. Therefore, the liquid cooling medium is supplied from the cooling medium supply device 12 into the plasma source 2 in order to cool the plasma generation electrode 8. For example, the cooling medium supply device 12 is used to uniformly disperse the liquid cooling medium in the entire back surface by spraying the liquid cooling medium to the back surface 8a of the plasma generation electrode 8 through the nozzles 17. The liquid cooling medium that is dispersed in the entire back surface of the plasma generation electrode 8 (the backing plate 7) in this way is evaporated while absorbing the heat transmitted to the back surface 8a as the evaporation heat, and hence cools the plasma source 2 including the plasma generation electrode 8.

The cooling medium that is used to cool the plasma generation electrode 8 in this way, that is, the evaporated cooling medium is introduced into the condensing chamber 35 of the condensing device 31 outside the vacuum chamber 4 through the evacuation tube 15. Since the heat exchanging portion 36 is provided inside the condensing chamber 35 and the cooling medium cooled by the cooling system 33 is circulated inside the heat exchanging portion 36, the space inside the condensing chamber 35 is kept at a low temperature, and hence the amount of the vapor of the cooling medium pressure is small. For this reason, the vapor of the cooling medium is liquefied while being suctioned into the condensing chamber 35, and is accumulated in the bottom portion of the condensing chamber 35 in a liquid state.

The pressure inside the condensing chamber 35 is defined in accordance with the type of the cooling medium and the cooling performance (the cooling temperature) of the cooling system 33. For example, in a case where the cooling medium is water and the temperature inside the condensing chamber 35 is 18°C to 30°C, the pressure of about 2 to 4.2 kPa corresponding to the saturation vapor pressure of the water at the temperature becomes the pressure inside the condensing chamber 35. A pressure obtained by adding the pressure loss of the evacuation tube 15 to that pressure becomes the pressure of the reduced pressure space 13. When the evacuation tube 15 is appropriately designed, the pressure loss of the evacuation tube 15 may be set to 5 kPa or less. For example, when the pressure loss of the evacuation tube 15 is 5 kPa, the pressure of the reduced pressure space 13 becomes 7 to 12.2 kPa. Further, when the pressure loss of the evacuation tube 15 is 1 kPa, the pressure of the reduced pressure space 13 becomes 3 to 5.2 kPa. At this time, the temperature of the plasma source 2 may be set to a temperature at which the pressure of the reduced pressure space 13 becomes the saturation vapor pressure of the cooling medium, that is, a temperature range of about 24°C to 50°C.

As the cooling system 33, a Freon refrigerating machine may be used, and the capability of the condenser 32 may be improved by the usage thereof.

As described above, since the condenser 32 liquefies the evaporated cooling medium, the pressure inside the condensing chamber 35 decreases to a pressure lower than the pressure of the reduced pressure space 13 inside the vacuum chamber 4. As a result, the vapor inside the reduced pressure space 13 flows into the condenser 32 through the evacuation tube 15. Thus, the condensing device 31 may exhibit the same action as that of the evacuation pump 16.

The auxiliary depressurizing portion 34 may not be provided, but it is desirable that the auxiliary depressurizing portion 34 be connected to the condenser 32. The auxiliary depressurizing portion 34 is used to auxiliary evacuate the inside of the condensing chamber 35, and hence the evacuation capability may be smaller than that of the evacuation pump 16 of the first embodiment. The vapor may be suctioned to a certain extent just by the depressurization function inside the condensing chamber 35 of the condenser 32 (the depressurization caused by the liquefaction of the cooling medium), but air or the like mixed in the reduced pressure space 13, the evacuation tube 15, and the condensing chamber 35 may not be evacuated. In that case, the mixed air may be evacuated by the operation of the auxiliary depressurizing portion 34. That is, the auxiliary depressurizing portion 34 may be used to evacuate a gas other than the cooling medium and to depressurize a start-up system. As described above, since the auxiliary depressurizing portion 34 is provided for a limited purpose, the capability thereof may be comparatively small, and hence a low-cost component may be employed.

The above-described condensing device 31 of the third embodiment may be used instead of the evacuation pump 16 of the second embodiment. That is, the condensing device 31 of the third embodiment may be employed instead of the evacuation pump 16 disclosed in Figs. 1 to 9. In addition, even in the third embodiment, the electric insulation portion 20 that electrically insulates the vacuum chamber 4 from the plasma source 2 may be provided between the evacuation tube 15 and the vacuum chamber 4, and the drain 21 may be provided so as to derive both the vapor of the cooling medium and the liquid cooling medium from the reduced pressure space 13 to the evacuation tube 15.

Furthermore, since the other configurations and effects of the third embodiment are substantially the same as those of the first embodiment, the description thereof will not be repeated.

Next, the vacuum plasma processing apparatus 3 according to a fourth embodiment of the present invention will be described.

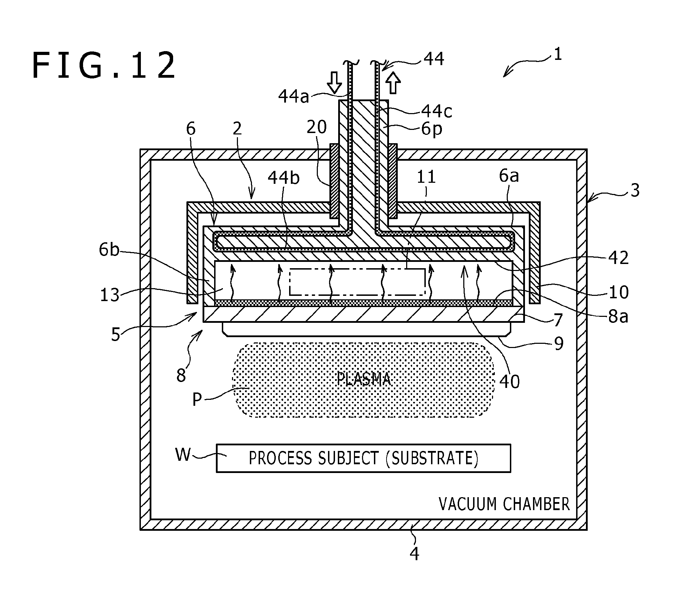

Fig. 12 illustrates an entire configuration of the vacuum plasma processing apparatus 3 according to the fourth embodiment. As in the first embodiment, the vacuum plasma processing apparatus 3 includes the plasma source 2, the vacuum chamber 4, the dark space shield 10, and the magnetic field generation device 11, and the plasma source 2 includes the plasma generation electrode 8 and the casing body 6. Then, these form the casing 5, and the reduced pressure space 13 is formed inside the casing 5. The above-described constituents are the same as those of the vacuum plasma processing apparatus according to the first embodiment, and hence the description thereof will not be repeated.

In the vacuum plasma processing apparatus 3 according to the fourth embodiment, the reduced pressure space 13 is evacuated so as to become a vacuum state, the cooling medium is enclosed inside the reduced pressure space 13, and the cooling medium is evaporated at the back surface 8a of the plasma generation electrode 8 as in the first embodiment, thereby robbing the heat (the evaporation heat) from the plasma generation electrode 8.

Further, the vacuum plasma processing apparatus 3 according to the fourth embodiment is characterized in that it includes a liquefaction device 40. The liquefaction device 40 liquefies the cooling medium evaporated inside the reduced pressure space 13, and the heat that is robbed from the plasma generation electrode 8 by the use of the liquefaction device 40 is discharged, that is, exhausted to the outside of the vacuum chamber 4 or the reduced pressure space 13.

As described above, in the cooling system of the related art that directly guides the liquid cooling medium to the plasma generation electrode so as to be circulated inside the plasma generation electrode, the plasma generation electrode (the backing plate) needs to be thick and rigid. However, in the cooling device 1 of the plasma source 2 according to the fourth embodiment, the reduced pressure space 13 encloses the cooling medium that robs heat from the plasma generation electrode 8 by the evaporation at the back surface of the plasma generation electrode 8 and the liquefaction device 40 liquefies the evaporated cooling medium, thereby uniformly and effectively cooling the plasma source 2.

Next, the cooling device 1 of the fourth embodiment will be described in detail.

As illustrated in Fig. 12, the cooling device 1 of the fourth embodiment is provided in the flat-plate-shaped plasma source 2 disposed in the horizontal direction, and cools the flat-plate-shaped plasma source 2.

As in the first embodiment, the lower portion of the plasma source 2 is formed by the plasma generation electrode 8. Further, the reduced pressure space 13 that is surrounded by the casing body 6 and the backing plate 7 as in the first embodiment is formed in the back surface of the plasma generation electrode 8, that is, the upper side in Fig. 12. The reduced pressure space 13 is air-tightly isolated from the space inside the vacuum chamber 4 without communicating with the outside of the vacuum chamber 4. The reduced pressure space 13 is evacuated in advance in a vacuum state (during the assembly of the plasma source 2), and then the cooling medium is enclosed in the reduced pressure space 13.

The cooling medium exists in a state where a part thereof is a liquid and the remaining part thereof is a gas (vapor) inside the reduced pressure space 13, and the pressure inside the reduced pressure space 13 becomes the saturation vapor pressure of the cooling medium at the temperature of the plasma source 2. As the cooling medium, water may be used. When the temperature of the plasma source 2 in an operation state is about 30°C to 60°C, the pressure of the reduced pressure space becomes a range of about 4.2 to 20 kPa in the pressure of the vapor of water. In a case where the cooling medium is not water, the pressure is defined by the relation between the vapor pressure of the medium and the target cooling temperature. However, it is desirable that the pressure do not exceed 50 kPa in order to keep the merit of the strength of the plasma source 2.

The liquid cooling medium in the cooling medium enclosed in the reduced pressure space 13 is evaporated while contacting the back surface 8a of the heated plasma generation electrode 8, and the evaporation heat is robbed from the plasma generation electrode 8 during the evaporation, thereby cooling the plasma generation electrode 8. Meanwhile, the vapor of the cooling medium is liquefied by the liquefaction device 40, and the evaporation heat is transmitted to the liquefaction device 40 during the liquefaction. In this way, the liquefied cooling medium is used for the evaporation at the back surface 8a again. That is, since the cooling medium alternately repeats the evaporation and the liquefaction inside the reduced pressure space 13, the heat applied to the plasma generation electrode 8 is robbed and is discharged to the outside of the plasma source 2, that is, the outside of the vacuum chamber 4.

The liquefaction device 40 cools the vapor of the cooling medium evaporated inside the reduced pressure space 13 so that the vapor is condensed into a liquid. Specifically, the liquefaction device 40 according to this embodiment includes a liquefaction surface 42 that is provided inside the reduced pressure space 13 and a cooling tube 44 that circulates low-temperature cooling water between the outside of the vacuum chamber 4 and the portion near the liquefaction surface 42. Then, the liquefaction surface 42 is cooled by the circulated cooling water, and the cooled liquefaction surface 42 contacts the vapor of the cooling medium so as to exchange heat therebetween, thereby promoting the liquefaction of the vapor of the cooling medium.

More specifically, the liquefaction device 40 according to this embodiment is formed by using the back wall 6a of the casing body 6, the liquefaction surface 42 is formed by the inner surface of the back wall 6a, and the cooling tube 44 is assembled into the back wall 42. The liquefaction surface 42 may have a fin-shaped structure that increases the contact area with respect to the vapor of the cooling medium so as to promote the liquefaction thereof. The liquefaction surface 42 according to this embodiment, that is, the inner surface of the back wall 6a of the casing body 6 is disposed so as to face the back surface 8a of the plasma generation electrode 8 with the reduced pressure space 13 interposed therebetween, and is disposed in parallel to the back surface 8a.

The cooling tube 44 is a tube through which the cooling water may be circulated, and one end thereof is connected to a cooling water supply source provided outside the vacuum chamber 4. The supply source is configured to supply the cooling water that has a temperature lower than the temperature of the reduced pressure space 13 and capable of liquefying the evaporated cooling medium into the cooling tube 44. The cooling tube 44 reaches the vicinity of the liquefaction surface 42 provided inside the vacuum chamber 4 so as to penetrate the casing body 6 from the supply source located at the outside of the vacuum chamber 4. More specifically, in this embodiment, the casing body 6 includes a penetration portion 6p that penetrates a portion from the back wall 6a to the vacuum chamber 4 so as to protrude toward the outside thereof in addition to the back wall 6a and the external wall 6b, and the cooling tube 44 includes a supply portion 44a that extends from the supply source to the back wall 6a through the penetration portion 6p, a meandering portion 44b that is connected to the first supply portion 44a and meanders inside the back wall 6a so as to extend horizontally along the liquefaction surface 42 in the vicinity of the liquefaction surface 42, and a return portion 44c that is connected to the meandering portion 44b and reaches the outside of the vacuum chamber 4 through the penetration portion 6p. Thus, the cooling tube is installed so as to uniformly cool the entire liquefaction surface 42 from the inside of the casing body 6 without any variation. That is, the cooling water is supplied from the outside of the vacuum chamber 4 to the portion near the liquefaction surface 42, and the heat absorbed to the cooling water by the heat exchange between the cooling water and the liquefaction surface 42 is emitted to the outside of the vacuum chamber 4 along with the cooling water.

Next, a method of using the vacuum plasma processing apparatus 3, and particularly, a method of cooling the plasma source 2 will be described.

Even in this description, a case will be described in which the sputtering deposition process is performed as in the first embodiment. In the sputtering deposition process, for example, the flat-plate-shaped plasma source (the sputter source) 2 and the substrate W are disposed in a horizontal posture, that is, a parallel posture inside the vacuum chamber 4, and hence the inside of the vacuum chamber 4 is evacuated as a vacuum state. Subsequently, a plasma generation gas (for example, Ar) is supplied into the vacuum chamber 4, and the plasma power supply applies a potential to the plasma source (the sputter source) 2, so that the plasma P is generated in the vicinity of the plasma generation electrode 8 of the plasma source 2.

The generation of the plasma P generates a large amount of heat in the front surface (that is, the target 9) of the plasma generation electrode 8. The generated heat is transmitted to the back surface 8a of the plasma generation electrode 8, that is, the upper surface of the backing plate 7 in this embodiment. In the back surface 8a, the liquid cooling medium exists while being deposited in a film state. Accordingly, when the heat is transmitted to the liquid cooling medium, the cooling medium is evaporated so as to become the vapor of the cooling medium. With the evaporation of the cooling medium, the evaporation heat is robbed from the back surface 8a, and hence the plasma generation electrode 8 is cooled.

Due to the evaporation of the cooling medium, the amount of the vapor of the cooling medium inside the reduced pressure space 13 increases, and the vapor pressure inside the reduced pressure space 13 increases. When the vapor pressure is located above the liquefaction surface 42, that is, the back surface 8a of the plasma generation electrode 8 in this embodiment and becomes higher than the saturation vapor pressure of the cooling medium at the temperature of the surface disposed so as to face the back surface 8a, that is, the downward direction, the vapor of the cooling medium of the liquefaction surface 42 is condensed and returned to a liquid. That is, the vapor is liquefied. During the liquefaction, the evaporation heat that is robbed from the back surface 8a to the cooling medium is transmitted to the liquefaction surface 42.

The cooling medium that is liquefied in this way is transferred to the wall surface inside the reduced pressure space 13 in the form of a liquid droplet or is dripped in the form of a liquid droplet, and is returned onto the back surface 8a of the plasma generation electrode 8 located below the reduced pressure space 13. In this way, the cooling medium alternately repeats the evaporation and the liquefaction, and the heat generated by the plasma generation electrode 8 is transmitted to the liquefaction surface 42.

Such phenomenon of the evaporation and the liquefaction substantially occur in the back surface 8a of the plasma generation electrode 8 and the liquefaction surface 42 as described above. However, since the pressure of the reduced pressure space 13 is a completely constant pressure, that is, a pressure corresponding to the vapor of the cooling medium pressure, the liquefaction of the cooling medium, that is, the heating of the inner wall surface of the casing 5 occurs at a relatively low-temperature place inside the reduced pressure space 13, and the evaporation of the cooling medium, that is, the cooling of the inner wall surface of the casing 5 occurs at a relatively high-temperature place when the liquid cooling medium exists therein. As a result, when the cooling medium exists in the back surface 8a of the plasma generation electrode 8 that receives heat, the wall surface surrounding the reduced pressure space efficiently exchanges heat with the vapor of the medium, and hence the wall surface has substantially the same temperature.

The heat that is transmitted to the liquefaction surface 42 in this way is transmitted to the outside of the vacuum chamber 4 by the cooling water that is circulated in the cooling tube 44 disposed so as to meander along the liquefaction surface 42 inside the liquefaction surface 42. Thus, when the cooling water is discharged to a drainage pit or the like, heat may be emitted to the outside along with the cooling water.

In the cooling device 1, the cooling tube 44 for circulating the cooling water may be provided at a place away from the plasma generation electrode 8 (the backing plate 7), and hence the cooling tube 44 does not need to be directly attached to the backing plate 7. Therefore, as in the cooling device of the related art, there is no need to increase the thickness of the plasma generation electrode 8 in accordance with the arrangement of the cooling tube 44. Further, the cooling device 1 may be easily provided even in the vacuum plasma processing apparatus in which the installation space for the cooling tube 44 may not be easily ensured in the vicinity of the plasma generation electrode 8.

In addition, in the cooling device 1, a place that is used to install the cooling tube 44 for circulating the cooling water may not be a narrow place like the vicinity of the plasma generation electrode 8, and may be a comparatively allowable place inside the casing body 6. That is, since the installation space may be set comparatively freely, a structure (for example, a disturbing plate or the like) generating a turbulence flow in the circulated cooling water may be provided inside the cooling tube 44 or a large-diameter tube capable of withstanding a large flow velocity may be used as the cooling tube 44. Thus, the degree of freedom in design of the vacuum plasma processing apparatus 3 may be improved.

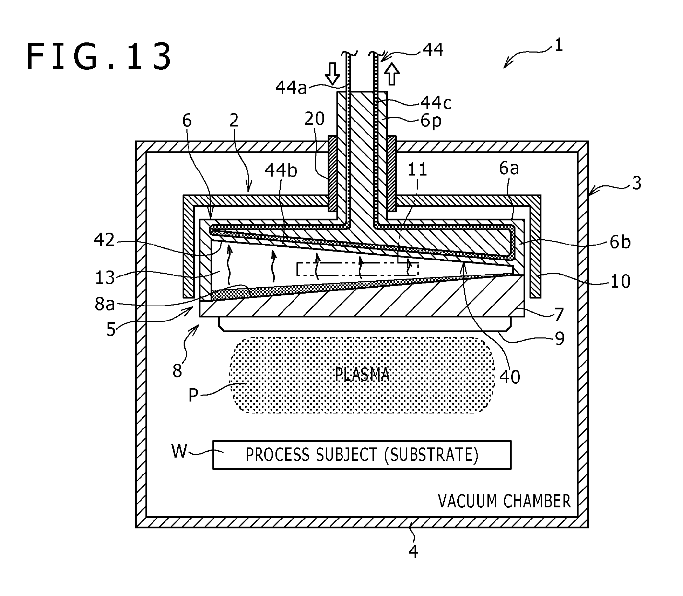

As illustrated in Fig. 13, the back surface 8a of the plasma generation electrode 8 may be a surface that is inclined with respect to the horizontal direction so that the liquid cooling medium is uniformly dispersed in the entire surface of the back surface 8a by the action of gravity. For example, as illustrated in Fig. 13, the inclined back surface 8a may be appropriately formed so that the back surface gradually increases in height from one end side (the left end side of Fig. 13) toward the other end side (the right end side of Fig. 13) in the horizontal direction.

Further, not only the back surface 8a but also the liquefaction surface 42 may be inclined. For example, the liquefaction surface 42 may be formed so that the liquefaction surface gradually decreases in height from one end side (the left end side of Fig. 13) toward the other end side (the right end side of Fig. 13) in the horizontal direction differently from the back surface.

Due to the inclination of the back surface 8a and the liquefaction surface 42 with respect to the horizontal direction, the liquid cooling medium that is liquefied in the liquefaction surface 42 flows along the inclined liquefaction surface 42 from the left end side toward the right end side by the action of gravity and then flows along the inclined back surface 8a of the plasma generation electrode 8 from the right end side toward the left end side so as to be evaporated. As a result, the liquid cooling medium may be reliably collected from the liquefaction surface 42, the collected liquid cooling medium may be used while being uniformly dispersed in the entire back surface, and the plasma source 2 may be efficiently cooled.

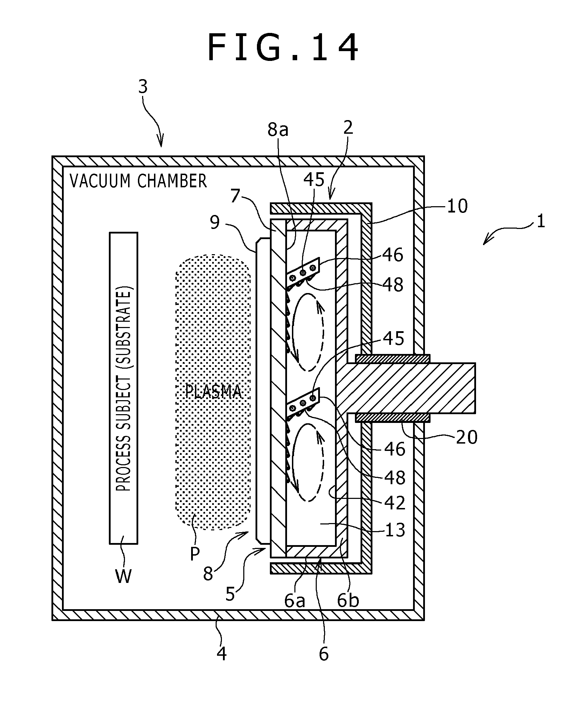

Further, the vacuum plasma processing apparatus 3 that may uniformly disperse the liquid cooling medium in the entire back surface by the action of gravity include a configuration in which the plasma source 2 is disposed in the perpendicular direction and the plasma generation electrode 8 is disposed so that the back surface 8a of the plasma generation electrode 8 becomes a perpendicular surface in the vertical direction as illustrated in Fig. 14. In this case, the liquefaction device may include at least one liquefaction member 46 having a plate shape as illustrated in Fig. 14. The liquefaction member 46 is attached to at least one position in the back surface 8a of the plasma generation electrode 8 provided as a perpendicular surface as described above. Desirably, the liquefaction member is attached to the back surface 8a so as to contact the back surface 8a at a plurality of positions as illustrated in the drawings. A lower surface 48 of the surface of each liquefaction member 46 forms the liquefaction surface of the lower surface 48. The lower surface 48 is a surface that is inclined with respect to the horizontal direction and is inclined so that the end opposite to the end contacting the back surface 8a is higher than the other end. Each liquefaction member 46 includes therein the cooling tube 45 that penetrates the liquefaction member in the horizontal direction or the approaching direction. As in the cooling tube 44, the cooling water that has a temperature lower than the liquefaction temperature of the cooling medium flows inside the cooling tube 45.

In this embodiment, the surface of the liquefaction member 46, that is, the lower surface 48 is effectively used as the liquefaction surface. Specifically, the cooling medium inside the reduced pressure space 13 is liquefied on the surface of the liquefaction member 46, flows on the particularly inclined lower surface 48 toward the back surface 8a, and flows along the back surface 8a, that is, the perpendicular surface so that the cooling medium is dropped from the back surface 8a. In this way, the evaporation of the cooling medium on the back surface 8a is promoted while the cooling medium is uniformly dispersed in the entire surface of the back surface 8a, and hence the plasma source 2 is effectively cooled.

As a method of dispersing the cooling medium in the entire back surface, a capillary action may be used. Although not illustrated in the drawings, the back surface of the plasma generation electrode 8 may be provided with a structure that uniformly disperses the liquid cooling medium in the entire back surface by the capillary action. For example, the structure may be a groove-shaped or mesh-shaped structure that guides the cooling medium. When the back surface 8a is provided with the structure that disperses the liquid cooling medium by the capillary action, the structure may help the operation of uniformly dispersing the liquid cooling medium in the entire surface of the back surface 8a, and hence may suppress a place where the liquid cooling medium locally disappears. Thus, it is possible to promote the uniform cooling of the plasma generation electrode 8.

Instead of this configuration or in addition to this configuration, in order to effectively and uniformly supply the liquid cooling medium to the back surface of the plasma generation electrode 8, a circulation device may be provided in which a liquid cooling medium reservoir is provided inside the reduced pressure space 13 and the cooling medium is supplied from the reservoir so as to be sprayed to the back surface of the plasma generation electrode.

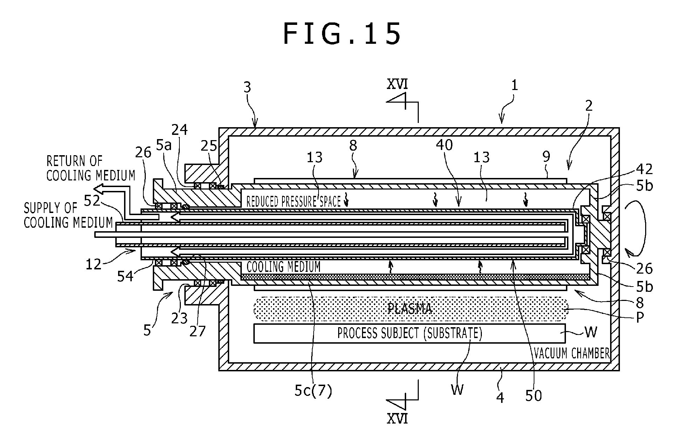

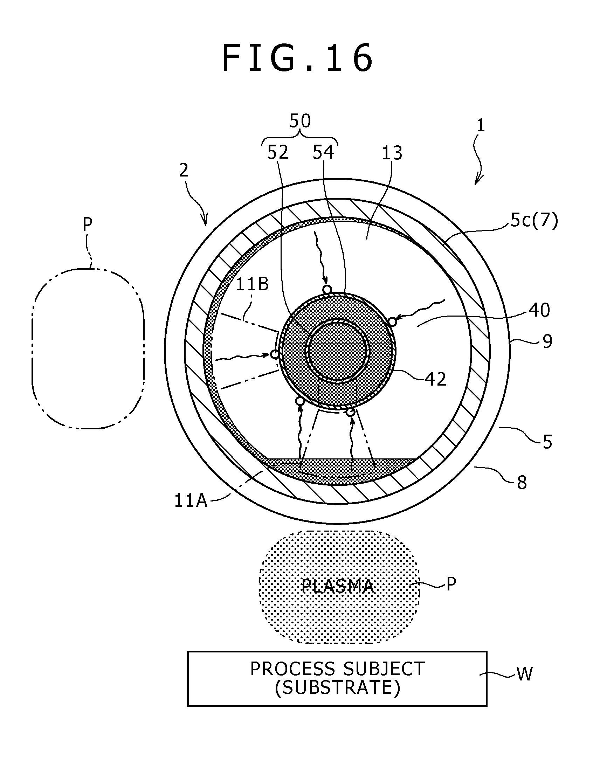

Next, the vacuum plasma processing apparatus 3 according to a fifth embodiment of the present invention will be described by referring to Figs. 15 and 16. As in the second embodiment, the vacuum plasma processing apparatus 3 according to the fifth embodiment includes the vacuum chamber 4, the plasma source 2 that includes the casing 5 with the cylindrical external wall 5c, and the rotational driving device (not illustrated) that rotates the casing 5 about the axis of the external wall 5c. Here, at least the outer peripheral portion of the external wall 5c is formed by the plasma generation electrode 8, and the plasma source 2 is disposed so as to be rotatable about the horizontal axis. Since the vacuum chamber 4 and the plasma source 2 are the same as those of the second embodiment, the description thereof will not be repeated, and only the difference from the second embodiment will be described.

As in the second embodiment, the casing 5 of the plasma source 2 is formed in a hollow shape and the reduced pressure space 13 is formed therein so as to be air-tightly isolated from the outside. However, the inside of the reduced pressure space 13 is evacuated in advance in a vacuum state, and then the cooling medium is enclosed inside the reduced pressure space 13. Also, a cooling tube unit 50 that constitutes the liquefaction device 40 is disposed in the reduced pressure space. The cooling tube unit 50 also includes a cylindrical outer peripheral surface, and the outer peripheral surface forms the liquefaction surface 42 of the liquefaction device 40. Further, a gap between the inner peripheral surface of the journal portion 5a of one end of the casing 5 and the outer peripheral surface of the cooling tube unit 50 is provided with a bearing portion 26 that allows the rotation of the casing 5 with respect to the cooling tube unit 50 and a sealing portion 27 that seals the gap therebetween regardless of the rotation. The bearing portion 26 is also provided between the cooling tube unit 50 and the end wall 5b of the other end of the casing 5.

In this configuration, the liquid cooling medium is obtained in a manner such that the vapor of the evaporated cooling medium inside the reduced pressure space 13 is liquefied while exchanging heat with the liquefaction surface 42.

As in the fourth embodiment, the liquefaction device 40 is used to liquefy, that is, condense the liquid cooling medium in a manner such that the vapor of the cooling medium evaporated in the back surface 8a of the plasma generation electrode 8 provided inside the casing 5 exchanges heat with the liquefaction surface 42 cooled by the circulation of the cooling water. The liquefaction device of the fifth embodiment is different from the fourth embodiment in that the cooling tube unit 50 is formed in a substantially columnar shape so as to be inserted into the cylindrical casing 5 and the surface, that is, the cylindrical outer peripheral surface thereof forms the liquefaction surface 42.

The cooling tube unit 50 includes a double-tube structure with a cylindrical inner tube 52 and a cylindrical outer tube 54 having an inner diameter larger than the outer diameter of the inner tube 52 and disposed outside the inner tube 52, and is disposed at a position where the axis matches the axis of the cylindrical casing 5 in a posture in which the axis is horizontal. The inner tube 52 has a shape of which both ends are opened, and the outer tube 54 has a shape in which only the end located at the outside of the vacuum chamber 4 of both ends is opened and the other end, that is, the end near the end wall 5b is closed. With respect to the cooling tube unit 50, the cooling water is supplied from the outside of the vacuum chamber 4 into the inner tube 52. Then, the cooling water is returned to the closed end of the outer tube 54, and is returned to the outside (the left side of Fig. 15) of the vacuum chamber 4 through a cylindrical passageway formed between the inner peripheral surface of the outer tube 54 and the outer peripheral surface of the inner tube 52. In this way, the cooling water is circulated.

The liquefaction surface 42 is formed by the outer peripheral surface of the outer tube 54, and the vapor of the cooling medium is liquefied by the cooling water flowing through both tubes 52 and 54, that is, the cooling water flowing inside the outer tube 54. The cooling medium that is cooled by the liquefaction surface 42 flows along the outer peripheral surface of the cooling tube 44 so as to be dropped therefrom, and is dripped to the inner surface of the plasma generation electrode 8, that is, the surface located below the cooling tube 44 in the back surface 8a. The cooling medium that is dripped in this way is uniformly coated and dispersed on the inner peripheral surface (the back surface of the plasma generation electrode 8) of the casing 5 with the rotation of the casing 5, and is provided for the evaporation again.

Even inside the casing 5 of the fifth embodiment, the magnetic field generation device 11 may be provided as in the configuration of the second embodiment. Further, the cylindrical plasma source 2 is not limited to the rotary magnetron sputter source, and may be also applied to a plasma CVD apparatus or an etching apparatus. This point is the same as that of the second embodiment.

Further, even in the plasma source 2 of the fifth embodiment, the plasma source 2 is not limited to the configuration in which the plasma source is disposed so as to be rotatable about the horizontal axis. As in the vacuum plasma processing apparatus 3 illustrated in Fig. 9, the plasma source 2 may be disposed so as to be rotatable about the inclined axis.

Next, the plasma source 2 and the vacuum plasma processing apparatus with the same of a sixth embodiment will be described.

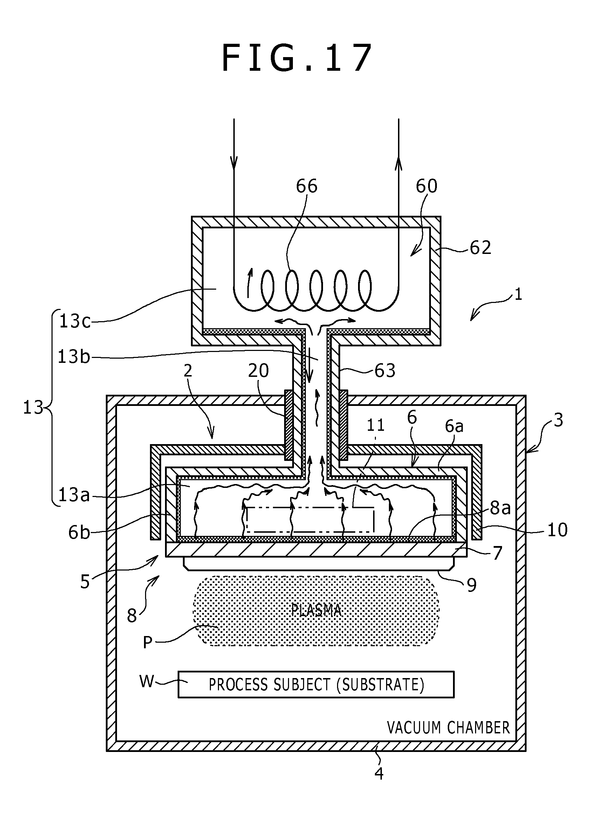

As illustrated in Fig. 17, in the apparatus of the sixth embodiment, in addition to the configuration in which the casing 5 having a hollow portion therein is formed by the plasma generation electrode 8 and the casing body 6, an expansion chamber 62 is connected to the casing 5 through a connection tube 63 and the connection tube 63 and the expansion chamber 62 constitute an expansion portion that forms an expansion space communicating with a casing inner space 13a inside the casing 5. That is, the tube inner space 13b inside the connection tube 63 and the chamber inner space 13c inside the expansion chamber 62 communicate with the casing inner space 13a, and these spaces 13a to 13c form one reduced pressure space 13. As in the fourth and fifth embodiments, the reduced pressure space 13 encloses therein the cooling medium that robs the heat (the evaporation heat) from the plasma generation electrode 8 by the evaporation of the back surface 8a of the plasma generation electrode 8, and a liquefaction device 60 for liquefying the evaporated cooling medium is provided in the chamber inner space 13c forming the expansion space.

The other configurations of the sixth embodiment are the same as those of the first embodiment or the second embodiment. For example, the configuration of the vacuum chamber 4 and the generation of the heat in the plasma source 2 with the generation of the plasma are substantially the same as those of the first or second embodiment. Therefore, in the description below, the expansion portion as the characteristic point of the sixth embodiment will be described in detail.

As illustrated in Fig. 17, in the plasma source 2 of the sixth embodiment, the plasma generation electrode 8 and the casing body 6 form the casing 5 that has a hollow portion (that is, a portion surrounding the casing inner space 13a) as in the first embodiment or the second embodiment. The connection tube 63 is a short and tubular member that extends upward from the upper center of the back wall 6a of the casing body 6, and extends outward so as to penetrate the upper wall of the vacuum chamber 4. The connection tube 63 has a diameter smaller than that of the casing 5 or the expansion chamber 62 (to be described later in detail), and enables the circulation of the cooling medium between the casing inner space 13a and the chamber inner space 13c.

The expansion chamber 62 is disposed so as to be adjacent to the upper wall of the vacuum chamber 4. The upper end of the connection tube 63 that extends upward from the vacuum chamber 4 is connected to the expansion chamber 62, so that the casing inner space 13a of the casing 5 communicates with the chamber inner space 13c of the expansion chamber 62 through the connection tube 63. In this way, the casing inner space 13a, the tube inner space 13b inside the connection tube 63, and the chamber inner space 13c inside the expansion chamber 62 form one reduced pressure space 13. That is, in this embodiment, the reduced pressure space 13 extends to the outside of the vacuum chamber 4.

As described above, the liquefaction device 60 is used to liquefy the cooling medium evaporated inside the expansion chamber 62, and includes a cooling coil 66 as a heat exchanger in this embodiment. The cooling medium is supplied from a cooling system (not illustrated) such as a cooling tower provided outside the expansion chamber 62 into the cooling coil 66 through the cooling tube. That is, in the sixth embodiment, the surface of the cooling coil 66 that is cooled by the cooling medium forms the liquefaction surface that liquefies the vapor of the cooling medium.

Next, a method of cooling the plasma source 2 of the apparatus will be described.

As in the fourth embodiment, a case will be considered in which the sputtering deposition process is performed by generating the plasma P in the vicinity of the plasma generation electrode 8 of the plasma source 2. When the plasma P is generated, a large amount of heat is generated in the surface of the plasma generation electrode 8.

In this way, the heat that is generated by the plasma generation electrode 8 is transmitted to the back surface 8a of the plasma generation electrode 8, that is, the upper surface of the backing plate 7. In the back surface 8a, the liquid cooling medium exists while being deposited in a film state. When the heat is transmitted to the liquid cooling medium, the liquid cooling medium is evaporated so as to become the vapor of the cooling medium. In accordance with the evaporation of the cooling medium, the evaporation heat is robbed from the back surface 8a of the plasma generation electrode 8 so that the plasma generation electrode 8 is cooled.

In this way, the cooling medium that is evaporated in the back surface 8a of the plasma generation electrode 8 is accumulated at the upper side of the casing inner space 13a, rises through the connection tube 63 opened to the back wall 6a of the casing body 6, and enters the chamber inner space 13c. In this way, the vapor of the cooling medium that moves to the chamber inner space 13c outside the vacuum chamber 4 is cooled and liquefied by the cooling coil 66 provided in the chamber inner space 13c. Specifically, the vapor of the cooling medium is condensed in the surface of the cooling coil 66 so as to be returned to the liquid cooling medium in a liquefied state, and the cooling medium that is liquefied in this way is dropped so as to be accumulated in the bottom portion of the expansion chamber 62. In this way, when the cooling medium is liquefied, the evaporation heat that is robbed from the back surface 8a of the plasma generation electrode 8 moves to the cooling medium of the cooling tube through the liquefaction surface 42, and the heat is emitted to the outside through the cooling tower.

The liquefied cooling medium flows downward along the inner wall surface of the connection tube 63 from the bottom portion of the expansion chamber 62, is returned to the casing inner space 13a, and is accumulated on the bottom portion of the casing 5, that is, the back surface of the plasma generation electrode 8. In this way, the cooling medium is evaporated by the casing inner space 13a in the reduced pressure space 13, and the evaporated cooling medium is liquefied by the chamber inner space 13c of the expansion chamber 62. By alternately repeating the cycle, the heat that is generated by the plasma generation electrode 8 is effectively emitted to the outside of the apparatus.

In this way, for example, when the expansion space (in this embodiment, the upper half portion of the tube inner space 13b and the chamber inner space 13c) is provided outside the vacuum chamber 4 at a position slightly distant from the plasma generation electrode 8 and the liquefaction device 60 including the cooling coil 66 is provided in the expansion space, there are several merits when the liquefied cooling medium is cooled by the liquefaction device. For example, since the reduced pressure space 13 may be freely expanded to a position other than the position near the back surface of the plasma generation electrode 8, an apparatus having a variety of configurations may be employed, and hence the degree of freedom in design of the vacuum plasma processing apparatus may be improved. Further, when the liquefaction device 60 used to emit the heat to the outside moves to the outside of the vacuum chamber 4, the volume of the casing 5 including the plasma generation electrode 8 may be decreased. When the volume of the casing 5 decreases, the vacuum chamber 4 may be decreased in size. Accordingly, for example, the time for depressurizing the inside of the vacuum chamber 4 may be shortened largely or the configuration of the cooling mechanism may be simplified.

In the present invention, the position of the expansion portion (in the sixth embodiment, the connection tube 63 and the expansion chamber 62) is not limited to the upper side of the plasma generation electrode 8, and may be appropriately changed in response to the position or the posture of the casing 5 or the plasma generation electrode 8.

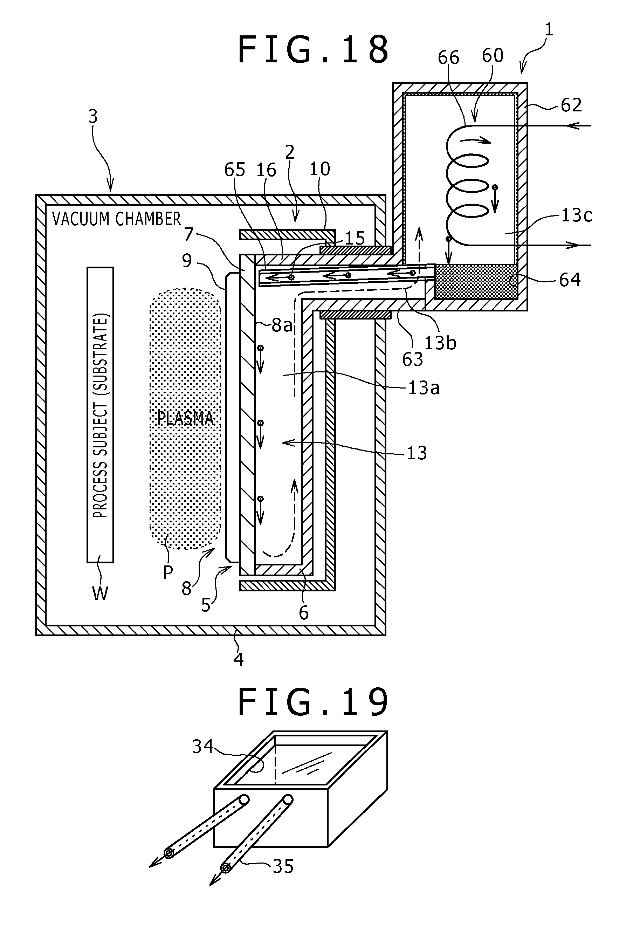

For example, in the example illustrated in Fig. 18, the casing 5 of the plasma source 2 is disposed so that the plasma generation electrode 8 faces the left and right direction. The connection tube 63 extends from the upper portion of the casing 5 to the outside of the vacuum chamber 4 so as to be gently inclined upward as it goes away from the plasma generation electrode 8 in the horizontal direction. The expansion chamber 62 is provided at the position outside the vacuum chamber 4, that is, the position adjacent to the upper portion of the vacuum chamber 4. When the connection tube 63 is connected to the expansion chamber 62, the casing inner space 13a and the chamber inner space 13c as the inner space of the expansion chamber 62 communicate with each other through the tube inner space 13b inside the connection tube 63. In this way, when one reduced pressure space 13 is formed and the chamber inner space 13c is provided with the cooling coil 66, the cooling medium that is evaporated in the casing 5 may be liquefied inside the expansion chamber 62, and hence the operation and the effect of the apparatus illustrated in Fig. 17 may be exhibited.

In the arrangement illustrated in Fig. 18, since the back surface 8a of the plasma generation electrode 8 is provided uprightly, it is difficult to uniformly disperse the liquid cooling medium in the entire back surface 8a as in the case where the back surface 8a extends in the horizontal direction. However, for example, the liquid cooling medium may not be uniformly dispersed by the reservoir 64 and the plurality of tube 65 illustrated in Figs. 18 and 19. The reservoir 64 is formed in the bottom portion of the expansion chamber 62 so as to accumulate the cooling medium liquefied by the cooling coil 66 in a trapped state. Each tube 65 extends from the reservoir 64 to the vicinity of the upper end of the plasma generation electrode 8 while being inclined downward so that the cooling medium flows downward from the reservoir 64 to the upper end of the plasma generation electrode 8.

The liquid cooling medium that is supplied to the upper end of the plasma generation electrode 8 by the reservoir 64 and the tube 65 flows downward so as to be dispersed on the back surface 8a of the plasma generation electrode 8. Accordingly, the liquid cooling medium may be uniformly dispersed in the entire back surface 8a of the plasma generation electrode 8.

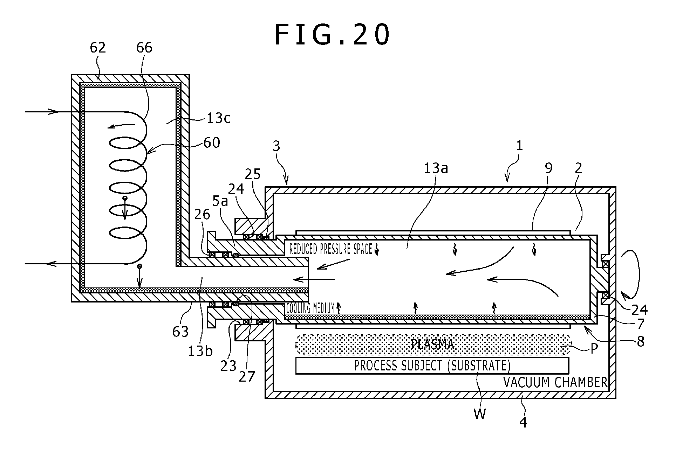

Further, in the seventh embodiment, as illustrated in Fig. 20, in a case where the plasma source 2 including a roll-shaped casing rotatable about the horizontal axis is cooled, the following configuration may be employed for the expansion portion.

As not in the sixth embodiment, the plasma source 2 illustrated in Fig. 20 includes the casing 5 with the cylindrical external wall 5c, the casing 5 is disposed inside the vacuum chamber 4 so that the axis extends in the horizontal direction and the casing is rotatable about the axis, and the outer peripheral portion of the external wall 5c is formed by the plasma generation electrode 8. Even this apparatus includes the tubular connection tube 63 and the expansion chamber 62 provided outside the vacuum chamber 4. Then, the connection tube 63 extends from the lower portion of the expansion chamber 62 toward the vacuum chamber 4, and is inserted into the vacuum chamber 4 so that the axis of the connection tube 63 matches the rotation shaft of the casing 5.

One end of the casing 5 forms the cylindrical journal portion 5a that is opened toward the lateral side (the left side in the example of the drawing), and rotatably supports the connection tube 63 through the bearing portion 26 and the sealing portion 27. That is, the relative rotation of the connection tube 63 is allowed while the air-tightness of the cylindrical casing 5 rotating about the horizontal axis with respect to the connection tube 63 is kept so that the connection tube 63 does not move. The connection tube 63 is a circular tube member that extends in the horizontal direction, and the end opposite to the end inserted into the casing 5 communicates with the bottom portion of the expansion chamber 62. The expansion chamber 62 is a frame-shaped member having a hollow portion formed therein, and the cooling coil 66 of the liquefaction device 60 is disposed in the chamber inner space 13c as the inner space as in the case of Fig. 17 or 18.

The structure that supports the casing 5 of the seventh embodiment is the same as that of Fig. 5, and the operation of the liquefaction device 60 is substantially the same as that of the sixth embodiment. Thus, the description thereof will not be repeated.

In the sixth and seventh embodiments illustrated in Figs. 17 to 20, the liquefaction device 60 that liquefies the vapor of the cooling medium includes the cooling coil 66. Then, the cooling coil 66 is provided inside the expansion chamber 62, and the cooling medium circulates inside the cooling coil 66, so that the vapor of the cooling medium is liquefied inside the expansion chamber 62. Such liquefaction causes the chamber inner space 13c inside the expansion chamber 62 to become a reduced pressure state and causes the gas cooling medium generated in the casing inner space 13a to be suctioned into the expansion chamber 62 without using a fluid mechanism such as a pump. However, the unit for liquefying the vapor of the cooling medium is not limited to the cooling coil 66. For example, a shell and tube type or a plate type heat exchanger may be used or the cooling tube may be provided inside the wall of the expansion portion (for example, the expansion chamber 62) or on the inner surface so as to surround the cooling tube. In this case, the wall surface may be directly and effectively cooled in a surrounded state. Further, when the cooling medium which is the same as the cooling medium stored in the reduced pressure space 13 is newly supplied into the space inside the expansion portion, that is, the expansion space, the expansion portion may be directly cooled by using the newly supplied cooling medium. Furthermore, in a case where the cooling medium is newly supplied into the expansion space in this way, it is desirable to provide a separate unit that discharges the cooling medium used for the heat exchange to the outside of the expansion portion so that the amount of the cooling medium existing inside the reduced pressure space becomes constant.

The expansion portion according to the sixth and seventh embodiments includes the expansion chamber 62 that is provided outside the vacuum chamber 4 and the connection tube 63 that connects the expansion chamber 62 to the casing 5, but the expansion portion according to the present invention is not limited thereto. For example, the reduced pressure space 13 may be increased in size in a manner such that the casing 5 is expanded to the outside of the vacuum chamber 4 in a specific direction so as to form the expansion portion. In this case, the vacuum chamber 4 may be provided with a hole that has a size in which the expansion portion may penetrate the hole.

The present invention is not limited to the above-described embodiments, and the shapes, the structures, the materials, and the combination of the constituents may be appropriately changed without departing from the spirit of the present invention. Further, in the embodiments disclosed herein, the items that are not explicitly defined, for example, the operation condition, the working condition, various parameters, and the dimension, the weight, and the volume of the constituent are easily set by the person skilled in the art without departing from the general scope considered by the person skilled in the art.

For example, water is desirable as the cooling medium, but a material other than the water may be used as long as the material is a liquid and is evaporated by the depressurization inside the reduced pressure space.

Further, the liquid or the vapor of the cooling medium collected by the evacuation pump 16 may be used again as the cooling medium of the cooling device 1 by the re-condensing.

Further, it is desirable that the vacuum plasma processing apparatus according to the present invention include a device that returns the inside of the casing 5 to the atmospheric pressure as the inside of the vacuum chamber 4 becomes the atmospheric pressure. In this apparatus, there is no need to provide a secure structure capable of withstanding the pressure difference between the inside and the outside of the plasma source 2, and hence the degree of freedom in design of the plasma source 2 is improved.

Further, the vacuum plasma processing apparatus according to the present invention may further include a unit that measures the pressure of the reduced pressure space, that is, the vapor pressure. When the measurement unit is provided, the cooling state may be monitored, the cooling medium supply amount may be adjusted based on the measurement result, and the evacuation capability of the evacuation device may be adjusted.

As described above, according to the present invention, the plasma source capable of uniformly and effectively cooling the plasma source while suppressing an increase in the size of the facility and an increase in cost, the vacuum plasma processing apparatus including the plasma source, and the plasma source cooling method are provided.

According to the present invention, the vacuum plasma processing apparatus includes the vacuum chamber of which the inside is evacuated to a vacuum state and the plasma source of the present invention, and the plasma source is provided inside the vacuum chamber. The plasma source includes a plasma generation electrode that generates plasma inside the vacuum chamber and a reduced pressure space forming member that forms a reduced pressure space accommodating and depressurizing a liquid cooling medium at the back surface of the plasma generation electrode, and the plasma generation electrode is cooled by the evaporation heat generated when the cooling medium is evaporated by a depressurization.

Further, according to the present invention, there is provided a plasma source cooling method for a vacuum plasma processing apparatus including a vacuum chamber of which the inside is evacuated to a vacuum state and a plasma source which is provided inside the vacuum chamber and includes a plasma generation electrode for generating plasma inside the vacuum chamber, the plasma source cooling method including: forming a reduced pressure space at the back surface of the plasma generation electrode; and evaporating a liquid cooling medium inside the reduced pressure space and cooling the plasma generation electrode by the evaporation heat.

With the above-described configuration, the plasma generation electrode may be uniformly and effectively cooled by using the evaporation heat of the cooling medium evaporated inside the reduced pressure space formed at the back surface of the plasma generation electrode.

The apparatus may further include an evacuation device that depressurizes the reduced pressure space so that the evaporation of the cooling medium inside the reduced pressure space is promoted.

In the plasma source, for example, the plasma generation electrode and the reduced pressure space forming member may form a casing surrounding the reduced pressure space, and a part of the outer wall forming the casing may be formed by the plasma generation electrode. In this way, the plasma generation electrode forming a part of the casing may be efficiently cooled by the evaporation of the cooling medium inside the casing.

The reduced pressure space forming member may form a casing including a cylindrical external wall along with the plasma generation electrode, and the plasma generation electrode may have a cylindrical shape and form at least a part of the external wall.

The cooling medium supply device may include a plurality of cooling medium spraying portions that are disposed at different positions inside the reduced pressure space, and may spray the cooling medium from the cooling medium spraying portions. Due to the distributed arrangement of the nozzles, the cooling medium may be further uniformly supplied.

The evacuation device may include an evacuation tube that guides the vapor of the cooling medium from the reduced pressure space to the outside of the vacuum chamber, an evacuation pump that suctions the vapor of the cooling medium through the evacuation tube, and an electric insulation portion that is provided between the evacuation tube and the vacuum chamber so as to electrically insulate the vacuum chamber and the plasma source from each other.

Further, the evacuation device may include an evacuation tube that guides the vapor of the cooling medium from the reduced pressure space to the outside of the vacuum chamber, an evacuation pump that suctions the vapor of the cooling medium through the evacuation tube, and a drain that derives both the vapor of the cooling medium and the liquid cooling medium from the reduced pressure space to the evacuation tube.

The back surface of the plasma generation electrode of the plasma source may be inclined with respect to the horizontal direction so that the liquid cooling medium is dispersed on the back surface by the action of gravity. Due to the inclination, the cooling medium may be uniformly supplied by the use of gravity.

Alternately, the back surface of the plasma generation electrode of the plasma source may be provided with a structure, for example, a groove-shaped or mesh-shaped structure that disperses the liquid cooling medium along the back surface by the capillary action.

As described above, in a case where the casing of the plasma source includes the cylindrical external wall, the casing may be disposed inside the vacuum chamber so as to be rotatable about the axis thereof and be formed so that the liquid cooling medium is dispersed in the entire inner peripheral surface of the plasma generation electrode with the rotation of the casing.

As described above, in a case where the casing of the plasma source includes the cylindrical external wall, the casing may be disposed inside the vacuum chamber so as to be rotatable about the axis thereof and be formed so that the cooling medium is dispersed in the inner peripheral surface of the cylindrical plasma generation electrode by the corporation of the rotation of the casing and the cooling medium spraying portions disposed in a distributed state in the rotation shaft direction.

As described above, in a case where the casing of the plasma source includes the cylindrical external wall, the casing may be disposed inside the vacuum chamber so as to be rotatable about the axis thereof in a posture in which the axis extends in the horizontal direction and be formed so that the liquid cooling medium accumulated at the lower side of the casing in a condensed state is uniformly coated and dispersed on the inner peripheral surface of the casing with the rotation of the electrode. Due to the arrangement of the plasma source, the circulation of the cooling medium inside the reduced pressure space is promoted, and hence the plasma generation electrode cooling efficiency may be improved.

As described above, in a case where the casing of the plasma source includes the cylindrical external wall, the casing may be disposed inside the vacuum chamber so as to be rotatable about the axis thereof in a posture in which the axis extends in the horizontal direction or is inclined with respect to the horizontal direction, and the evacuation device may include a drain that drives the liquid cooling medium accumulated in the reduced pressure space in a condensed state to the evacuation tube and a pumping portion that pumps the liquid cooling medium accumulated at the lower side of the cylindrical casing in a condensed state to the upper side of the casing by the use of the rotation of the casing and discharges the liquid cooling medium to the drain in addition to the evacuation tube and the evacuation pump.

Desirably, the evacuation device may include an evacuation tube that guides the vapor of the cooling medium from the reduced pressure space to the outside of the vacuum chamber and a condensing device that suctions the vapor of the cooling medium along the evacuation tube and liquefies the suctioned cooling medium. The cooling medium may be used again by the condensing device.

Desirably, the condensing device may include a condenser that liquefies the cooling medium therein and an auxiliary depressurizing portion that depressurizes the inside of the condenser.

Desirably, the condensing device may include a transportation tube that is used to transport the cooling medium liquefied by the condenser to the reduced pressure space.

Desirably, an electric insulation member that is provided between the evacuation tube and the vacuum chamber so as to electrically insulate the plasma source from the vacuum chamber may be further provided.

Desirably, the evacuation device may include a drain that derives both the vapor of the cooling medium and the liquid cooling medium from the reduced pressure space to the evacuation tube.

The cooling method includes: forming the reduced pressure space; and evaporating the liquid cooling medium inside the reduced pressure space, and the cooling method may further include evacuating the inside of the reduced pressure space so that the evaporation of the cooling medium supplied to the reduced pressure space is promoted.

Further, in the vacuum plasma processing apparatus according to the present invention, the inside of the reduced pressure space may be evacuated and the cooling medium is enclosed inside the reduced pressure space, and a liquefaction device may be provided so as to liquefy the cooling medium evaporated in the reduced pressure space. Since the liquefaction device liquefies again the cooling medium that is used to cool the plasma generation electrode by the evaporation inside the reduced pressure space, the cooling medium may be repeatedly used for the cooling operation.

In the plasma source, for example, the plasma generation electrode and the reduced pressure space forming member may form a casing surrounding the reduced pressure space, a part of the outer wall forming the casing may be formed by the plasma generation electrode, and the liquefaction device may be provided inside the casing.

The plasma source may include a casing with a cylindrical external wall, and at least the outer peripheral portion of the external wall may form the plasma generation electrode. In this case, when the liquefaction device is provided at the axis position of the cylindrical external wall, the cooling medium evaporated inside the reduced pressure space may be efficiently liquefied.

The back surface of the plasma generation electrode of the plasma source may be inclined with respect to the horizontal direction so that the liquid cooling medium is dispersed on the back surface by the action of gravity. Due to the inclination, the cooling medium may be uniformly supplied by the use of gravity.

Alternately, the back surface of the plasma generation electrode of the plasma source may be provided with a structure that disperses the liquid cooling medium along the back surface by the capillary action.

As described above, in a case where the casing of the plasma source includes the cylindrical external wall, the casing may be disposed inside the vacuum chamber so as to be rotatable about the axis of the external wall in a posture in which the axis extends in the horizontal direction and b formed so that the liquid cooling medium accumulated at the lower side of the casing is uniformly coated and dispersed on the inner peripheral surface of the casing with the rotation of the electrode. Due to the arrangement of the plasma source, the circulation of the cooling medium inside the reduced pressure space is promoted, and hence the plasma generation electrode cooling efficiency may be improved.

Desirably, the apparatus may further include an expansion portion that forms an expansion space communicating with a space near the back surface of the plasma generation electrode of the plasma source and forming the reduced pressure space along with the space near the back surface in addition to the space near the back surface, and the liquefaction device may be provided in the expansion portion and liquefies the evaporated cooling medium. Due to the expansion portion, a place for liquefying the cooling medium may be set a place away from the plasma generation electrode, and the degree of freedom in design of the apparatus may be improved.

Further, when the expansion space formed by the expansion portion exists outside the vacuum chamber, the vacuum chamber may be decreased in size.

For example, the reduced pressure space forming member may form a flat-plate-shaped casing along with the plasma generation electrode, the expansion portion may be connected to the casing so that the inside of the casing communicates with the expansion space, and the plasma generation electrode may form one outer wall forming the casing.

In this case, when the expansion portion is located above the plasma generation electrode, the cooling medium liquefied in the expansion portion may be smoothly returned to the back surface of the plasma generation electrode.

The reduced pressure space forming member may form a casing including a cylindrical external wall along with the plasma generation electrode. In this case, since the plasma generation electrode forms at least a part of the external wall and the expansion portion extends from the axis position of the casing to the outside of the vacuum chamber so that the expansion space communicates with the inside of the casing, the cooling medium inside the casing may be smoothly derived to the expansion space.

The cooling method includes: forming the reduced pressure space; and evaporating the liquid cooling medium inside the reduced pressure space. Further, the cooling method may include: evacuating the inside of the reduced pressure space and enclosing the liquid cooling medium therein; and liquefying the cooling medium evaporated inside the reduced pressure space by the liquefaction device so as to become the liquid cooling medium.

## Claims

1. A plasma source that is provided inside a vacuum chamber evacuated so that the inside becomes a vacuum state and constitutes a vacuum plasma processing apparatus along with the vacuum chamber, the plasma source comprising:
a plasma generation electrode that generates plasma inside the vacuum chamber; and
a reduced pressure space forming member that forms a reduced pressure space in a back surface of the plasma generation electrode, the reduced pressure space containing a liquid cooling medium and being capable of depressurizing;
wherein the plasma generation electrode is cooled by evaporation heat generated when the cooling medium evaporates.

2. The plasma source according to claim 1, further comprising:
a cooling medium supply device that supplies a liquid cooling medium to the back surface of the plasma generation electrode; and
an evacuation device that evacuates and depressurizes the reduced pressure space so as to promote the evaporation of the supplied cooling medium.

3. The plasma source according to claim 2,
wherein the plasma generation electrode and the reduced pressure space forming member of the plasma source form a casing therein so that the casing surrounds the reduced pressure space, and a part of an outer wall forming the casing is formed by the plasma generation electrode.

4. The plasma source according to claim 2,
wherein the reduced pressure space forming member forms a casing including a cylindrical external wall along with the plasma generation electrode, and the plasma generation electrode has a cylindrical shape and forms at least a part of the external wall.

5. The plasma source according to claim 2,
wherein the cooling medium supply device includes a plurality of cooling medium spraying portions that are disposed at different positions inside the reduced pressure space, and spray the cooling medium from the cooling medium spraying portions.

6. The plasma source according to claim 2,
wherein the back surface of the plasma generation electrode is inclined with respect to the horizontal direction so that the liquid cooling medium is dispersed on the back surface by the action of gravity.

7. The plasma source according to claim 2,
wherein the back surface of the plasma generation electrode is provided with a structure that disperses the liquid cooling medium along the back surface by the capillary action.

8. The plasma source according to claim 4,
wherein the casing with the cylindrical external wall is disposed so as to be rotatable about the axis thereof, and is configured to disperse the liquid cooling medium in the entire inner peripheral surface of the plasma generation electrode with the rotation of the casing.

9. The plasma source according to claim 8,
wherein the cooling medium supply device includes a plurality of cooling medium spraying portions that are disposed at a plurality of positions in a direction parallel to the axis inside the reduced pressure space, and the cooling medium is coated and dispersed on an inner peripheral surface of the cylindrical plasma generation electrode by the corporation of an operation of rotating the casing and an operation of spraying the cooling medium from the cooling medium spraying portions.

10. The plasma source according to claim 8,
wherein the casing including the cylindrical external wall is disposed inside the vacuum chamber so as to be rotatable about the axis thereof in a posture in which the axis thereof extends in the horizontal direction, and the liquid cooling medium accumulated at the lower side of the casing in a condensed state is uniformly coated and dispersed on the inner peripheral surface of the casing with the rotation of the casing.

11. The plasma source according to claim 2,
wherein the evacuation device includes an evacuation tube that guides the vapor of the cooling medium from the reduced pressure space to the outside of the vacuum chamber and a condensing device that suctions the vapor of the cooling medium along the evacuation tube and liquefies the suctioned cooling medium vapor.

12. The plasma source according to claim 11,
wherein the condensing device includes a condenser that condenses the cooling medium therein and an auxiliary depressurizing portion that depressurizes a pressure inside the condenser.

13. The plasma source according to claim 11,
wherein the condensing device includes a transportation tube that is used to transport the cooling medium liquefied by the condenser to the reduced pressure space.

14. The plasma source according to claim 11,
wherein the evacuation device includes a drain that derives both the vapor of the cooling medium and the liquid cooling medium from the reduced pressure space to the evacuation tube.

15. The plasma source according to claim 1,
wherein the reduced pressure space encloses the cooling medium therein while the reduced pressure space is evacuated, and
wherein the plasma source further comprises a liquefaction device that liquefies the cooling medium evaporated inside the reduced pressure space.

16. The plasma source according to claim 15,
wherein the plasma generation electrode and the reduced pressure space forming member form the casing that surrounds the reduced pressure space, and a part of an outer wall forming the casing is formed by the plasma generation electrode.

17. The plasma source according to claim 16,
wherein the liquefaction device is disposed so as to face a back surface of the plasma generation electrode with the reduced pressure space interposed therebetween.

18. The plasma source according to claim 15,
wherein the reduced pressure space forming member forms a casing including a cylindrical external wall along with the plasma generation electrode, at least the outer peripheral portion of the external wall thereof is formed by the plasma generation electrode, and the liquefaction device is provided at the axis position of the cylindrical external wall.

19. The plasma source according to claim 15,
wherein the back surface of the plasma generation electrode is inclined with respect to the horizontal direction so that the liquid cooling medium is dispersed on the back surface thereof by the action of gravity.

20. The plasma source according to claim 15,
wherein the back surface of the plasma generation electrode is provided with a structure that disperses the liquid cooling medium along the back surface by the capillary action.

21. The plasma source according to claim 15, further comprising:
an expansion portion that forms an expansion space communicating with a space near the back surface of the plasma generation electrode and forming the reduced pressure space along with the space near the back surface in addition to the space near the back surface,
wherein the liquefaction device is provided in the expansion portion and liquefies the evaporated cooling medium.

22. The plasma source according to claim 21,
wherein the reduced pressure space forming member forms a flat-plate-shaped casing along with the plasma generation electrode, the expansion portion is connected to the casing so that the inside of the casing communicates with the expansion space, and the plasma generation electrode forms one outer wall forming the casing.

23. The plasma source according to claim 22,
wherein the expansion portion is located above the plasma generation electrode.

24. The plasma source according to claim 21,
wherein the reduced pressure space forming member forms a casing including a cylindrical external wall along with the plasma generation electrode, the plasma generation electrode forms at least a part of the external wall thereof, and the expansion portion extends from the axis position of the casing to the outside of the vacuum chamber so that the expansion space communicates with the inside of the casing.

25. A vacuum plasma processing apparatus comprising:
a vacuum chamber of which the inside is evacuated to a vacuum state; and
the plasma source according to claim 1,
wherein the plasma source is provided inside the vacuum chamber.

26. The vacuum plasma processing apparatus according to claim 25, further comprising:
a cooling medium supply device that supplies the liquid cooling medium to the back surface of the plasma generation electrode; and
an evacuation device that evacuates and depressurizes the reduced pressure space so that the evaporation of the supplied cooling medium is promoted.

27. The vacuum plasma processing apparatus according to claim 26,
wherein the plasma generation electrode and the reduced pressure space forming member of the plasma source form a casing surrounding the reduced pressure space, and at part of an outer wall forming the casing is formed by the plasma generation electrode.

28. The vacuum plasma processing apparatus according to claim 27,
wherein the reduced pressure space forming member forms a casing including a cylindrical external wall along with the plasma generation electrode, and the plasma generation electrode has a cylindrical shape and forms at least a part of the external wall thereof.

29. The vacuum plasma processing apparatus according to claim 26,
wherein the cooling medium supply device includes a plurality of cooling medium spraying portions that are disposed at different positions inside the reduced pressure space and spray the cooling medium from the cooling medium spraying portions.

30. The vacuum plasma processing apparatus according to claim 26,
wherein the evacuation device includes an evacuation tube that guides the vapor of the cooling medium from the reduced pressure space to the outside of the vacuum chamber, an evacuation pump that suctions the vapor of the cooling medium through the evacuation tube, and an electric insulation portion that is provided between the evacuation tube and the vacuum chamber so as to electrically insulate the vacuum chamber and the plasma source from each other.

31. The vacuum plasma processing apparatus according to claim 26,
wherein the evacuation device includes an evacuation tube that guides the vapor of the cooling medium from the reduced pressure space to the outside of the vacuum chamber, an evacuation pump that suctions the vapor of the cooling medium through the evacuation tube, and a drain that derives both the vapor of the cooling medium and the liquid cooling medium from the reduced pressure space to the evacuation tube.

32. The vacuum plasma processing apparatus according to claim 26,
wherein the back surface of the plasma generation electrode of the plasma source is inclined with respect to the horizontal direction so that the liquid cooling medium is dispersed on the back surface by the action of gravity.

33. The vacuum plasma processing apparatus according to claim 26,
wherein the back surface of the plasma generation electrode of the plasma source is provided with a structure that disperses the liquid cooling medium along the back surface by the capillary action.

34. The vacuum plasma processing apparatus according to claim 28,
wherein the casing including the cylindrical external wall of the plasma source is disposed so as to be rotatable about the axis thereof and is formed so that the liquid cooling medium is dispersed on the entire inner peripheral surface of the plasma generation electrode with the rotation of the casing.

35. The vacuum plasma processing apparatus according to claim 34,
wherein the cooling medium supply device includes a plurality of cooling medium spraying portions that are disposed at a plurality of positions in a direction parallel to the axis inside the reduced pressure space, and the cooling medium is coated and dispersed on an inner peripheral surface of the cylindrical plasma generation electrode by the corporation of an operation of rotating the casing and an operation of spraying the cooling medium from the cooling medium spraying portions.

36. The vacuum plasma processing apparatus according to claim 34,
wherein the casing including the cylindrical external wall of the plasma source is disposed inside the vacuum chamber so as to be rotatable about the axis thereof in a posture in which the axis thereof extends in the horizontal direction, and the liquid cooling medium accumulated at the lower side of the casing in a condensed state is uniformly coated and dispersed on the inner peripheral surface of the casing with the rotation of the casing.

37. The vacuum plasma processing apparatus according to claim 28,
wherein the casing of the cylindrical plasma source is disposed inside the vacuum chamber so as to be rotatable about the axis thereof in a posture in which the axis extends in the horizontal direction or is inclined with respect to the horizontal direction, and the evacuation device includes an evacuation tube that guides the vapor of the cooling medium from the reduced pressure space to the outside of the vacuum chamber, an evacuation pump that suctions the vapor of the cooling medium through the evacuation tube, an electric insulation portion that is provided between the evacuation tube and the vacuum chamber so as to electrically insulate the vacuum chamber and the plasma source from each other, a drain that derives the liquid cooling medium accumulated in the reduced pressure space in a condensed state to the evacuation tube, and a pumping portion that pumps the liquid cooling medium accumulated at the lower side of the cylindrical casing to the upper side of the casing by using the rotation of the casing and discharges the liquid cooling medium to the drain.

38. The vacuum plasma processing apparatus according to claim 26,
wherein the evacuation device includes an evacuation tube that guides the vapor of the cooling medium from the reduced pressure space to the outside of the vacuum chamber and a condensing device that suctions the vapor of the cooling medium along the evacuation tube and liquefies the suctioned cooling medium.

39. The vacuum plasma processing apparatus according to claim 38,
wherein the condensing device includes a condenser that condenses the cooling medium and an auxiliary depressurizing portion that depressurizes a pressure inside the condenser.

40. The vacuum plasma processing apparatus according to claim 38,
wherein the condensing device includes a transportation tube that is used to transport the cooling medium liquefied by the condenser to the reduced pressure space.

41. The vacuum plasma processing apparatus according to claim 38, further comprising:
an electric insulation member that is provided between the evacuation tube and the vacuum chamber so as to electrically insulate the plasma source from the vacuum chamber.

42. The vacuum plasma processing apparatus according to claim 38,
wherein the evacuation device includes a drain that derives both the vapor of the cooling medium and the liquid cooling medium from the reduced pressure space to the evacuation tube.

43. The vacuum plasma processing apparatus according to claim 25,
wherein the reduced pressure space encloses the cooling medium therein while the reduced pressure space is evacuated, and
wherein the vacuum plasma processing apparatus further comprises a liquefaction device that liquefies the cooling medium evaporated inside the reduced pressure space.

44. The vacuum plasma processing apparatus according to claim 43,
wherein the plasma generation electrode and the reduced pressure space forming member of the plasma source form the casing that surrounds the reduced pressure space, and a part of an outer wall forming the casing is formed by the plasma generation electrode.

45. The vacuum plasma processing apparatus according to claim 44,
wherein the liquefaction device is disposed so as to face a back surface of the plasma generation electrode with the reduced pressure space interposed therebetween.

46. The vacuum plasma processing apparatus according to claim 43,
wherein the plasma generation electrode and the reduced pressure space forming member of the plasma source form a casing including a cylindrical external wall, at least the outer peripheral portion of the external wall is formed by the plasma generation electrode, and the liquefaction device is provided at the axis position of the cylindrical external wall.

47. The vacuum plasma processing apparatus according to claim 43,
wherein the back surface of the plasma generation electrode of the plasma source is inclined with respect to the horizontal direction so that the liquid cooling medium is dispersed on the back surface by the action of gravity.

48. The vacuum plasma processing apparatus according to claim 43,
wherein the back surface of the plasma generation electrode of the plasma source is provided with a structure that disperses the liquid cooling medium along the back surface by the capillary action.

49. The vacuum plasma processing apparatus according to claim 43, further comprising:
an expansion portion that forms an expansion space communicating with a space near the back surface of the plasma generation electrode of the plasma source and forming the reduced pressure space along with the space near the back surface in addition to the space near the back surface,
wherein the liquefaction device is provided in the expansion portion and liquefies the evaporated cooling medium.

50. The vacuum plasma processing apparatus according to claim 49,
wherein the expansion space provided with the expansion portion exists outside the vacuum chamber.

51. The vacuum plasma processing apparatus according to claim 49,
wherein the reduced pressure space forming member forms a flat-plate-shaped casing along with the plasma generation electrode, the expansion portion is connected to the casing so that the inside of the casing communicates with the expansion space, and the plasma generation electrode forms one outer wall forming the casing.

52. The vacuum plasma processing apparatus according to claim 51,
wherein the expansion portion is located above the plasma generation electrode.

53. The vacuum plasma processing apparatus according to claim 49,
wherein the reduced pressure space forming member forms a casing including a cylindrical external wall along with the plasma generation electrode, the plasma generation electrode forms at least a part of the external wall thereof, and the expansion portion extends from the axis position of the casing to the outside of the vacuum chamber so that the expansion space communicates with the inside of the casing.

54. A plasma source cooling method for a vacuum plasma processing apparatus including a vacuum chamber of which the inside is evacuated to a vacuum state and a plasma source which is provided inside the vacuum chamber and includes a plasma generation electrode for generating plasma inside the vacuum chamber, the plasma source cooling method comprising:
forming a reduced pressure space at the back surface of the plasma generation electrode; and
evaporating a liquid cooling medium inside the reduced pressure space and cooling the plasma generation electrode by the evaporation heat.

55. The plasma source cooling method according to claim 54, further comprising:
evacuating and depressurizing the reduced pressure space so that the evaporation of the cooling medium supplied to the reduced pressure space is evaporated.

56. The plasma source cooling method according to claim 54, further comprising:
evacuating the inside of the reduced pressure space and enclosing the cooling medium inside the reduced pressure space; and
liquefying the cooling medium evaporated inside the reduced pressure space by a liquefaction device so as to become a liquid cooling medium.
